# EUROPEAN PATENT APPLICATION

(11) **EP 4 542 650 A1**
(43) Date of publication of application: **23.04.2025**
(21) Application number: 23826807.2
(22) Date of filing: 27.04.2023
(51) Int. Cl.: H01L 27/146, H04N 25/70

(54) **SOLID-STATE IMAGING DEVICE**

(30) Priority: 20.06.2022 JP 2022099008
(71) Applicant: Sony Semiconductor Solutions Corporation, Atsugi-shi, Kanagawa 243-0014 (JP)
(72) Inventor: HIRAMATSU, Tomoki, Atsugi-shi, Kanagawa 243-0014 (JP); SATO, Yusuke, Atsugi-shi, Kanagawa 243-0014 (JP)
(74) Representative: Müller Hoffmann & Partner
(86) International application number: PCT/JP2023/016659
(87) International publication number: WO 2023/248618

(57) **Abstract**

A solid-state imaging device includes: a first electrode, supplied with a fixed voltage, partially surrounding a periphery of a first pixel; a charge transfer layer, transferring electric charge, disposed at least in a region opposed to the first electrode and corresponding to the first pixel; a photoelectric conversion layer, converting light into electric charge, disposed on the charge transfer layer oppositely to the first electrode; an electrode disposed on the photoelectric conversion layer oppositely to the charge transfer layer and supplying a voltage thereto; first and second accumulation electrodes each accumulating electric charge in the charge transfer layer and disposed to be spaced apart on the charge transfer layer oppositely to the photoelectric conversion layer in a region corresponding to the first pixel; and a first control electrode disposed between the first and second accumulation electrodes and transferring one of electric charge accumulated by the first and second accumulation electrodes.

## Description

### Technical Field

The present disclosure relates to a solid-state imaging device.

### Background Art

PTL 1 discloses an imaging element. In this imaging element, phase difference detection pixels that detect a phase difference are arranged in a portion of a pixel array section in which a plurality of pixels is arrayed. The detection of a phase difference by the phase difference detection pixels enables detection of a focus position of a subject, thus making it possible to achieve autofocus that automatically brings an imaging lens into focus.

A pixel is configured by stacking, on a photoelectric conversion section that converts incident light into electric charge, an individual on-chip lens that condenses incident light individually for each pixel.

Meanwhile, the phase difference detection pixel is configured by arranging two pixels adjacently. The phase difference detection pixel is configured by stacking, on photoelectric conversion sections of two pixels, a common on-chip lens common to the two pixels. In the common on-chip lens, incident light incident on a side of one pixel is condensed on a photoelectric conversion section of another pixel, and incident light incident on a side of the other pixel is condensed on a photoelectric conversion section of the one pixel.

In addition, PTL 2 discloses a solid-state imaging element. In this solid-state imaging element, in the same manner as the imaging element disclosed in PTL 1, phase difference detection pixels are arranged in a portion of a pixel array section in which a plurality of pixels is arrayed.

The pixel includes a photoelectric conversion film that converts incident light into electric charge, and electrodes that sandwich upper and lower sides of the photoelectric conversion film.

Meanwhile, the phase difference detection pixel is configured by two pixels with pixel areas varied from the pixel. The variation of the pixel area is achieved by changing an area of the electrode.

### Citation List

### Patent Literature

PTL 1: International Publication No. WO2021/045139
PTL 2: Japanese Unexamined Patent Application Publication No. 2015-50331

### Summary of the Invention

In an imaging element disclosed in PTL 1 mentioned above, a portion of an individual on-chip lens is changed into a common on-chip lens to form a phase difference detection pixel. Meanwhile, in a solid-state imaging element disclosed in PTL 2, a pixel area of some of pixels is changed to form a phase difference detection pixel. That is, the phase difference detection pixel is arranged fixedly at a predetermined position of a pixel array section.

It is desired, in the solid-state imaging device, to simply arrange phase difference detection pixels in a predetermined region or across the entire surface of a pixel region (pixel array section).

A solid-state imaging device according to a first aspect of the present disclosure includes: a first electrode disposed to surround a portion of a periphery of a first pixel and being supplied with a fixed voltage; a charge transfer layer disposed at least in a region that is opposed to the first electrode and corresponds to the first pixel, the charge transfer layer transferring electric charge; a photoelectric conversion layer disposed on the charge transfer layer on a side opposite to the first electrode, the photoelectric conversion layer converting light into electric charge; an electrode disposed on the photoelectric conversion layer on a side opposite to the charge transfer layer, the electrode supplying the photoelectric conversion layer with a voltage; a first accumulation electrode and a second accumulation electrode disposed to be spaced apart from each other on the charge transfer layer on a side opposite to the photoelectric conversion layer in a region corresponding to the first pixel, the first accumulation electrode and the second accumulation electrode each accumulating electric charge in the charge transfer layer; and a first control electrode disposed between the first accumulation electrode and the second accumulation electrode, the first control electrode transferring one of pieces of electric charge accumulated by the first accumulation electrode and the second accumulation electrode.

In a solid-state imaging device according to a second aspect of the present disclosure, the first accumulation electrode and the second accumulation electrode are disposed to be spaced apart from each other in a first direction, in the solid-state imaging device according to the first embodiment. Further, in the solid-state imaging device according to the second embodiment, a second pixel is disposed in a second direction intersecting the first direction, with respect to the first pixel. The second pixel includes: the first electrode disposed to surround a portion of a periphery of the second pixel and being supplied with a fixed voltage; the charge transfer layer disposed at least in a region that is opposed to the first electrode and corresponds to the second pixel, the charge transfer layer transferring electric charge; the photoelectric conversion layer disposed on the charge transfer layer on the side opposite to the first electrode, the photoelectric conversion layer converting light into electric charge; the electrode disposed on the photoelectric conversion layer on the side opposite to the charge transfer layer, the electrode supplying the photoelectric conversion layer with a voltage; a third accumulation electrode and a fourth accumulation electrode disposed to be spaced apart from each other in the first direction on the charge transfer layer on the side opposite to the photoelectric conversion layer in a region corresponding to the second pixel, the third accumulation electrode and the fourth accumulation electrode each accumulating electric charge in the charge transfer layer; and a second control electrode disposed between the third accumulation electrode and the fourth accumulation electrode, the second control electrode transferring one of pieces of electric charge accumulated by the third accumulation electrode and the fourth accumulation electrode.

### Brief Description of the Drawings

[FIG. 1] FIG. 1 is a schematic plan view (chip layout diagram) of a solid-state imaging device according to a first embodiment of the present disclosure.
[FIG. 2] FIG. 2 is a schematic plan view of a plurality of pixels of the solid-state imaging device according to the first embodiment.
[FIG. 3] FIG. 3 is a longitudinal cross-sectional view (a cross-sectional view taken along a cutting line A-A illustrated in FIG. 2) of the solid-state imaging device and the pixel illustrated in FIG. 2.
[FIG. 4] FIG. 4 is an energy potential diagram of the pixel illustrated in FIGs. 2 and 3 during non-saturated accumulation.
[FIG. 5] FIG. 5 is an energy potential diagram of the pixel illustrated in FIGs. 2 and 3 at the start of transfer illustrated in FIGs. 2 and 3.
[FIG. 6] FIG. 6 is an energy potential diagram of the pixel illustrated in FIGs. 2 and 3 during the transfer.
[FIG. 7] FIG. 7 is an energy potential diagram of the pixels illustrated in FIGs. 2 and 3 at the end of the transfer.
[FIG. 8] FIG. 8 is an explanatory timing chart of a relationship between time and a voltage supplied to the pixel illustrated in FIGs. 2 and 3.
[FIG. 9] FIG. 9 is an explanatory timing chart of a relationship between time and a voltage supplied to a pixel of a solid-state imaging device according to a first modification example of the first embodiment.
[FIG. 10] FIG. 10 is an explanatory timing chart of a relationship between time and a voltage supplied to a pixel of a solid-state imaging device according to a second modification example of the first embodiment.
[FIG. 11] FIG. 11 is a longitudinal cross-sectional view, corresponding to FIG. 3, of a solid-state imaging device and a pixel according to a second embodiment of the present disclosure.
[FIG. 12] FIG. 12 is a schematic plan view, corresponding to FIG. 2, of a plurality of pixels of a solid-state imaging device according to a third embodiment of the present disclosure.
[FIG. 13] FIG. 13 is a schematic plan view, corresponding to FIG. 2, of a plurality of pixels of a solid-state imaging device according to a fourth embodiment of the present disclosure.
[FIG. 14] FIG. 14 is a schematic plan view, corresponding to FIG. 2, of a plurality of pixels of a solid-state imaging device according to a fifth embodiment of the present disclosure.
[FIG. 15] FIG. 15 is a schematic plan view, corresponding to FIG. 2, of a plurality of pixels of a solid-state imaging device according to a sixth embodiment of the present disclosure.
[FIG. 16] FIG. 16 is a schematic plan view, corresponding to FIG. 2, of a plurality of pixels of a solid-state imaging device according to a seventh embodiment of the present disclosure.
[FIG. 17] FIG. 17 is an energy potential diagram, corresponding to FIG. 4, of the pixel illustrated in FIG. 16 during non-saturated accumulation.
[FIG. 18] FIG. 18 is an energy potential diagram, corresponding to FIG. 5, of the pixel illustrated in FIG. 16 at the start of transfer.
[FIG. 19] FIG. 19 is an energy potential diagram, corresponding to FIG. 6, of the pixel illustrated in FIG. 16 during the transfer.
[FIG. 20] FIG. 20 is an energy potential diagram, corresponding to FIG. 7, of the pixel illustrated in FIG. 16 at the end of the transfer.
[FIG. 21] FIG. 21 is an explanatory timing chart of a relationship between time and a voltage supplied to the pixel illustrated in FIG. 16.
[FIG. 22] FIG. 22 is an explanatory timing chart of a relationship between time and a voltage supplied to a pixel of a solid-state imaging device according to a first modification example of the seventh embodiment.
[FIG. 23] FIG. 23 is an explanatory timing chart of a relationship between time and a voltage supplied to a pixel of a solid-state imaging device according to a second modification example of the seventh embodiment.
[FIG. 24] FIG. 24 is a schematic plan view, corresponding to FIG. 2, of a plurality of pixels of a solid-state imaging device according to an eighth embodiment of the present disclosure.
[FIG. 25] FIG. 25 is a schematic plan view, corresponding to FIG. 2, of a plurality of pixels of a solid-state imaging device according to a ninth embodiment of the present disclosure.
[FIG. 26] FIG. 26 is a schematic plan view, corresponding to FIG. 2, of a plurality of pixels of a solid-state imaging device according to a tenth embodiment of the present disclosure.
[FIG. 27] FIG. 27 is a schematic plan view, corresponding to FIG. 2, of a plurality of pixels of a solid-state imaging device according to an eleventh embodiment of the present disclosure.
[FIG. 28] FIG. 28 is a longitudinal cross-sectional view, corresponding to FIG. 3, of a plurality of pixels of a solid-state imaging device according to a twelfth embodiment of the present disclosure.
[FIG. 29] FIG. 29 is a longitudinal cross-sectional view, corresponding to FIG. 3, of a plurality of pixels of a solid-state imaging device according to a thirteenth embodiment of the present disclosure.
[FIG. 30] FIG. 30 is a longitudinal cross-sectional view, corresponding to FIG. 3, of a plurality of pixels of a solid-state imaging device according to a fourteenth embodiment of the present disclosure.
[FIG. 31] FIG. 31 is a block diagram of an electronic apparatus according to a fifteenth embodiment of the present disclosure.
[FIG. 32] FIG. 32 is a configuration diagram of a photodetection system including a photodetector according to a sixteenth embodiment of the present disclosure.
[FIG. 33] FIG. 33 is a circuit configuration diagram of the photodetection system illustrated in FIG. 32.
[FIG. 34] FIG. 34 is a block diagram depicting an example of schematic configuration of a vehicle control system.
[FIG. 35] FIG. 35 is a diagram of assistance in explaining an example of installation positions of an outside-vehicle information detecting section and an imaging section.
[FIG. 36] FIG. 36 is a view depicting an example of a schematic configuration of an endoscopic surgery system.
[FIG. 37] FIG. 37 is a block diagram depicting an example of a functional configuration of a camera head and a camera control unit (CCU).

### Modes for Carrying Out the Invention

Hereinafter, description is given in detail of embodiments of the present disclosure with reference to the drawings. It is to be noted that the description is given in the following order.

### 1. First Embodiment

A first embodiment describes a first example in which the present technology is applied to a solid-state imaging device. The first embodiment describes an overall configuration of the solid-state imaging device, a configuration of a pixel, and an operation of the pixel.

### 2. Second Embodiment

A second embodiment describes a second example in which a cross-sectional structure of an accumulation electrode and a control electrode of the pixel are changed in the solid-state imaging device according to the first embodiment.

### 3. Third Embodiment

A third embodiment describes a third example in which a configuration of the control electrode is changed in the solid-state imaging device according to the first embodiment or the second embodiment.

### 4. Fourth Embodiment

A fourth embodiment describes a fourth example in which the configuration of the control electrode is changed in the solid-state imaging device according to the first embodiment or the second embodiment.

### 5. Fifth Embodiment

A fifth embodiment describes a fifth example in which an electrode is further provided in the solid-state imaging device according to the first embodiment or the second embodiment.

### 6. Sixth Embodiment

A sixth embodiment describes a sixth example in which the solid-state imaging device according to the fourth embodiment and the solid-state imaging device according to the fifth embodiment are combined.

### 7. Seventh Embodiment

A seventh embodiment describes a seventh example in which a switch element is further provided in the solid-state imaging device according to the fifth embodiment.

### 8. Eighth Embodiment

An eighth embodiment describes an eighth example in which a switch element is further provided in the solid-state imaging device according to the third embodiment.

### 9. Ninth Embodiment

A ninth embodiment describes a ninth example in which a switch element is further provided in the solid-state imaging device according to the sixth embodiment.

### 10. Tenth Embodiment

A tenth embodiment describes a tenth example in which an arrangement mode of the accumulation electrode and the control electrode of the pixel are changed in the solid-state imaging device according to the first embodiment or the second embodiment.

### 11. Eleventh Embodiment

An eleventh embodiment describes an eleventh example in which the solid-state imaging device according to the fourth embodiment and the solid-state imaging device according to the tenth embodiment are combined.

### 12. Twelfth Embodiment

A twelfth embodiment describes a twelfth example in which a cross-sectional structure of the pixel is changed in the solid-state imaging device according to the first embodiment.

### 13. Thirteenth Embodiment

A thirteenth embodiment describes a thirteenth example in which the cross-sectional structure of the pixel is changed in the solid-state imaging device according to the first embodiment.

### 14. Fourteenth Embodiment

A fourteenth embodiment describes a fourteenth example in which the cross-sectional structure of the pixel is changed in the solid-state imaging device according to the first embodiment.

### 15. Fifteenth Embodiment

A fifteenth embodiment describes a fifteenth example in which the present technology is applied to an electronic apparatus including the solid-state imaging device according to any of the first embodiment to the fourteenth embodiment.

### 16. Sixteenth Embodiment

A sixteenth embodiment describes a sixteenth example in which the present technology is applied to a photodetection system including the solid-state imaging device according to any of the first embodiment to the fourteenth embodiment.

### 17. Example of Practical Application to Mobile Body

This practical application example describes an example in which the present technology is applied to a vehicle control system which is an example of a mobile body control system.

### 18. Example of Practical Application to Endoscopic Surgery System

This practical application example describes an example in which the present technology is applied to an endoscopic surgery system.

### 19. Other Embodiments

### <1. First Embodiment>

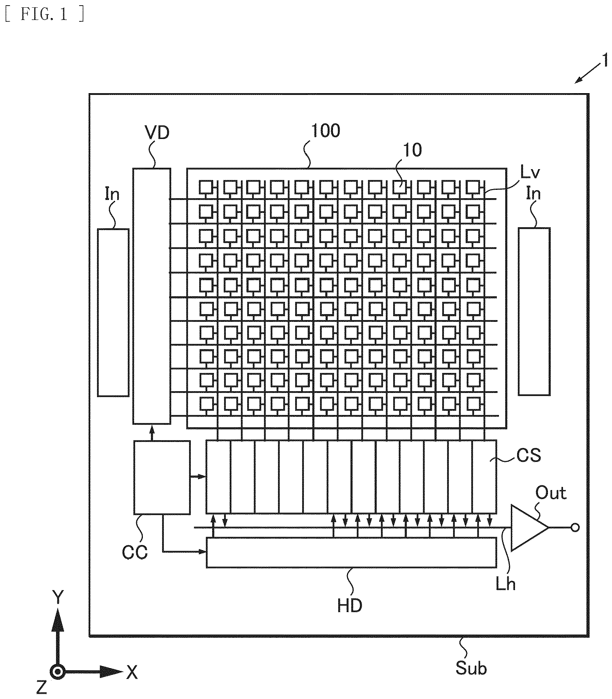

Description is given of a solid-state imaging device 1 according to the first embodiment of the present disclosure with reference to FIGs. 1 to 10.

Here, an arrow-X direction indicated as appropriate in the drawings indicates one planar direction of the solid-state imaging device 1 placed on a plane for convenience. An arrow-Y direction indicates another planar direction orthogonal to the arrow-X direction. In addition, an arrow-Z direction indicates an upward direction orthogonal to the arrow-X direction and the arrow-Y direction. That is, the arrow-X direction, the arrow-Y direction, and the arrow-Z direction exactly coincide with an X-axis direction, a Y-axis direction, and a Z-axis direction, respectively, of a three-dimensional coordinate system.

It is to be noted that these directions are each indicated to aid understanding of descriptions, and are not intended to limit directions used in the present technology.

### [Configuration of Solid-State Imaging Device 1]

### (1) Overall Configuration of Solid-State Imaging Device 1

FIG. 1 illustrates an example of a schematic planar configuration of an example of the solid-state imaging device 1 according to the first embodiment. Here, the solid-state imaging device 1 is a CMOS solid-state imaging device. In addition, the solid-state imaging device 1 is a photodetector that converts incident light incident from the outside into electric charge.

The solid-state imaging device 1 is mainly configured by a semiconductor substrate Sub, e.g., an Si substrate. The solid-state imaging device 1 includes, in the semiconductor substrate Sub, a pixel region (pixel array section) 100 in which a plurality of pixels 10 is two-dimensionally and regularly arrayed, and a peripheral circuit.

The pixel 10 includes an unillustrated photoelectric conversion element that converts incident light into electric charge, and a plurality of pixel transistors. The pixel transistor is configured by a so-called insulated-gate field-effect transistor (IGFET).

The plurality of pixel transistors includes three transistors, e.g., a transfer transistor, a reset transistor, and an amplification transistor. In addition, the pixel transistor may be configured by four transistors by further adding a selection transistor.

An equivalent circuit of a unit pixel is similar to that of the normal one, and thus detailed illustration and description thereof are omitted.

In addition, the pixel 10 may have a shared pixel structure. The shared pixel structure includes a plurality of photoelectric conversion elements, a plurality of transfer transistors, one shared floating diffusion, and a shared pixel transistor.

The peripheral circuit includes a vertical drive circuit VD, a column signal processing circuit CS, a horizontal drive circuit HD, an output circuit Out, a control circuit CC, and the like.

The control circuit CC receives an input clock and data instructing an operation mode or the like, and outputs data such as internal information on the solid-state imaging device 1. That is, the control circuit CC generates, on the basis of a vertical synchronization signal, a horizontal synchronization signal, and a master clock, clock signals and control signals that serve as a standard for operations of the vertical drive circuit VD, the column signal processing circuit CS, the horizontal drive circuit HD, and the like. Further, these signals are inputted to the vertical drive circuit VD, the column signal processing circuit CS, the horizontal drive circuit HD, and the like.

The vertical drive circuit VD includes, for example, a shift register. The vertical drive circuit VD selects pixel drive wiring, and supplies the selected pixel drive wiring with a pulse to drive the pixel 10. The pixel 10 is driven on a row-by-row basis. That is, the vertical drive circuit VD sequentially and selectively scans the pixels 10 of a pixel region 100 in a vertical direction on a row-by-row basis. Signal charge generated in response to a received light amount in a photoelectric conversion element of each of the pixels 10 through a vertical signal line Lv is supplied as a pixel signal to the column signal processing circuit CS.

The column signal processing circuit CS is arranged for each column, for example, of the pixel 10. In the column signal processing circuit CS, signal processing such as noise removal is performed for each pixel column on signals outputted from the pixels 10 of one row. That is, the column signal processing circuit CS performs signal processing such as CDS (Correlated Double Sampling) to remove a fixed pattern noise unique to the pixel 10, signal amplification, and AD conversion. An unillustrated horizontal selection switch is coupled between an output stage of the column signal processing circuit CS and a horizontal signal line Lh.

The horizontal drive circuit HD is configured by a shift register, for example. The horizontal drive circuit HD sequentially outputs horizontal scanning pulses to thereby select the respective column signal processing circuits CS, and outputs the pixel signals from the respective column signal processing circuits CS to the horizontal signal line Lh.

The output circuit Out performs signal processing on signals sequentially supplied from the respective column signal processing circuits CS through the horizontal signal line Lh, and outputs the signals. For example, in a case where only buffering is performed, the output circuit Out may perform black level adjustment, column dispersion correction, various types of digital signal processing, and the like, in some cases. An input/output terminal In exchanges signals between the solid-state imaging device 1 and the outside thereof.

### (2) Configuration of Pixel 10

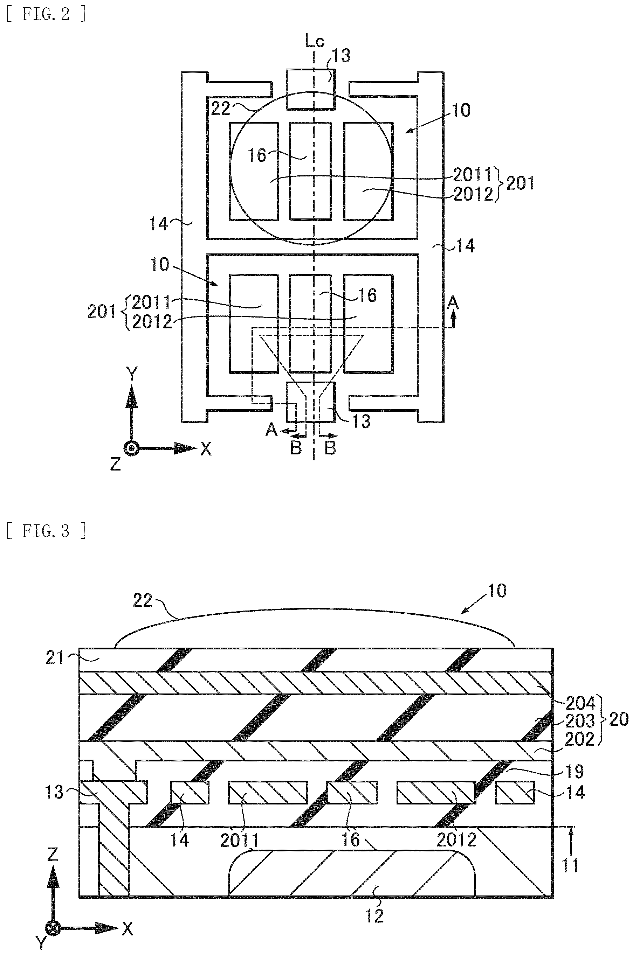

FIG. 2 illustrates an example of a schematic planar configuration of the pixel 10 of the solid-state imaging device 1. FIG. 3 illustrates an example of a longitudinal cross-sectional configuration of the pixel 10 illustrated in FIG. 2. FIG. 3 illustrates a cross-section taken along a cutting line A-A illustrated in FIG. 2.

As illustrated in FIG. 3, the pixel 10 includes an inorganic photoelectric conversion section 12 and an organic photoelectric conversion section 20 that are sequentially stacked on a semiconductor substrate (refer to a reference symbol Sub indicated in FIG. 1). As illustrated in FIGs. 2 and 3, the pixel 10 is formed in a rectangular shape having two sides opposed to each other in the arrow-X direction and two sides opposed to each other in the arrow-Y direction, as viewed in the arrow-Z direction (hereinafter, simply referred to as "in a plan view"). Further, the pixel 10 includes an optical lens 22 for each of the pixels 10.

### (3) Configuration of First Electrode 14

Detailed description is given. In one pixel 10, at least a portion of a periphery is surrounded by a first electrode 14. As for the first electrode 14, another pixel 10 arranged adjacently to the pixel 10 in the arrow-X direction and in the arrow-Y direction shares the first electrode 14.

The first electrode 14 extends in the arrow-X direction, and is disposed to be spaced apart with a certain interval in the arrow-Y direction. In addition, the first electrode 14 extends in the arrow-Y direction, and is disposed to be spaced apart with a certain interval in the arrow-X direction. That is, the first electrode 14 is formed in a lattice shape in a plan view. The pixel 10 is disposed in a region defined by the first electrode 14 formed in a lattice shape. The first electrode 14 is supplied with a fixed voltage.

It is to be noted that, here, the first electrode 14 is not disposed in a region where a floating diffusion 13 is disposed that is shared by adjacent pixels 10. In addition, in FIG. 2, the pixel 10 arranged on the lower side corresponds to a "first pixel" according to the present technology. Meanwhile, in FIG. 2, the pixel 10 arranged on the upper side corresponds to a "second pixel" according to the present technology.

### (4) Configuration of Inorganic Photoelectric Conversion Section 12

The inorganic photoelectric conversion section 12 is disposed in a semiconductor layer 11 stacked on the semiconductor substrate Sub on a light incident side. For example, an Si single crystalline layer is used for the semiconductor layer 11. The semiconductor layer 11 is a p-type semiconductor region doped with p-type impurities as a first electrically-conductive type.

The inorganic photoelectric conversion section 12 is disposed in the semiconductor layer 11, and is formed by an n-type semiconductor region of a second electrically-conductive type, which is an electrically-conductive type opposite to the first electrically-conductive type. That is, the inorganic photoelectric conversion section 12 is configured by a p-n junction diode.

### (5) Configuration of Organic Photoelectric Conversion Section 20

The organic photoelectric conversion section 20 is configured by sequentially stacking, on the semiconductor layer 11, an accumulation electrode 201, a charge transfer layer 202, a photoelectric conversion layer 203, and an electrode 204.

### (5-1) Configuration of Accumulation Electrode 201

The accumulation electrode 201 is disposed on the semiconductor layer 11 in a region corresponding to the pixel 10. In other words, the accumulation electrode 201 is disposed between the semiconductor layer 11 and the charge transfer layer 202 on the charge transfer layer 202 on a side opposite to the photoelectric conversion layer 203. The accumulation electrode 201 is disposed for each of the pixels 10. In other words, the accumulation electrode 201 is a lower electrode of the organic photoelectric conversion section 20.

In the first embodiment, the accumulation electrode 201 includes two divided accumulation electrodes, i.e., a first accumulation electrode 2011 and a second accumulation electrode 2012. In a plan view, the first accumulation electrode 2011 is formed in a rectangular shape having a length in the arrow-Y direction being longer than a length in the arrow-X direction, although a planar shape thereof is not particularly limited. The second accumulation electrode 2012 is disposed to be spaced apart in the arrow-X direction from the first accumulation electrode 2011. In a plan view, the second accumulation electrode 2012 is formed to be line-symmetric about a virtual line Lc relative to the first accumulation electrode 2011. The virtual line Lc extends in the arrow-Y direction between the first accumulation electrode 2011 and the second accumulation electrode 2012. That is, in the same manner as the first accumulation electrode 2011, the second accumulation electrode 2012 is formed in a rectangular shape.

The accumulation electrode 201 accumulates, in the charge transfer layer 202, electric charge converted from light in the photoelectric conversion layer 203. Further, the first accumulation electrode 2011 and the second accumulation electrode 2012 construct a phase difference detection pixel that detects a phase difference.

The first accumulation electrode 2011 and the second accumulation electrode 2012 are each formed by the same electrically-conductive layer and by the same electrically-conductive material. For example, an indium oxide-zinc oxide-based oxide (IZO: Indium Zinc Oxide) or indium tin oxide (ITO: Indium Tin Oxide) is used for each of the first accumulation electrode 2011 and the second accumulation electrode 2012. The first accumulation electrode 2011 and the second accumulation electrode 2012 are each formed to have a film thickness of 10 nm or more and 100 nm or less, for example.

Here, in the pixel (a first pixel) 10 arranged on the lower side in FIG. 2, the first accumulation electrode 2011 corresponds to a "first accumulation electrode" according to the present technology, and the second accumulation electrode 2012 corresponds to a "second accumulation electrode" according to the present technology. Meanwhile, in the pixel (a second pixel) 10 arranged on the upper side in FIG. 2, the first accumulation electrode 2011 corresponds to a "third accumulation electrode" according to the present technology, and the second accumulation electrode 2012 corresponds to a "fourth accumulation electrode" according to the present technology.

### (5-2) Configuration of Charge Transfer Layer 202

The charge transfer layer 202 is disposed on the accumulation electrode 201 with an insulator 19 interposed therebetween. Here, the charge transfer layer 202 is formed across a region corresponding to the plurality of pixels 10. The charge transfer layer 202 is a transparent semiconductor that transmits an electromagnetic wave in a visible light region. The charge transfer layer 202 accumulates electric charge converted from light in the photoelectric conversion layer 203.

In addition, a portion of the charge transfer layer 202 is coupled to the floating diffusion 13. The floating diffusion 13 is coupled to an unillustrated pixel circuit.

As the charge transfer layer 202, for example, IGZO is used that includes indium (In), gallium (Ga), zinc (Zn), and oxygen (O). In addition, as the charge transfer layer 202, there may be used IGSiO including In, Ga, Si, and O, or IAZO including In, aluminum (Al), Zn, and O, for example.

The charge transfer layer 202 is formed to have a film thickness of 10 nm or more and 100 nm or less, for example.

### (5-3) Configuration of Photoelectric Conversion Layer 203

The photoelectric conversion layer 203 is disposed on the charge transfer layer 202. In the same manner as the charge transfer layer 202, here, the photoelectric conversion layer 203 is formed across a region corresponding to the plurality of pixels 10. The photoelectric conversion layer 203 converts incident light into electric charge.

An organic material is used for the photoelectric conversion layer 203. As the organic material, there may be used any of a p-type organic semiconductor, an n-type organic semiconductor, a stacked structure of a p-type organic semiconductor and an n-type organic semiconductor, and a mixture (bulk hetero structure) of a p-type organic semiconductor and an n-type organic semiconductor.

The stacked structure includes a stacked structure in which the p-type organic semiconductor, the mixture (bulk hetero structure) of a p-type organic semiconductor and an n-type organic semiconductor, and the n-type organic semiconductor are each stacked. In addition, the stacked structure includes a stacked structure in which the p-type organic semiconductor and the mixture (bulk hetero structure) of a p-type organic semiconductor and an n-type organic semiconductor are each stacked. Further, the stacked structure includes a stacked structure in which the n-type organic semiconductor and the mixture (bulk hetero structure) of a p-type organic semiconductor and an n-type organic semiconductor are each stacked. It is to be noted that the stacking order of the stacked structure may be changed as appropriate.

Examples of the p-type organic semiconductor may include a naphthalene derivative, an anthracene derivative, a phenanthrene derivative, a pyrene derivative, a perylene derivative, a tetracene derivative, a pentacene derivative, a quinacridone derivative, a thiophene derivative, a thienothiophene derivative, a benzothiophene derivative, a benzothienobenzothiophene derivative, a triallylamine derivative, a carbazole derivative, a perylene derivative, a picene derivative, a chrysene derivative, a fluoranthene derivative, a phthalocyanine derivative, a subphthalocyanine derivative, a subporphyrazine derivative, a metal complex including a heterocyclic compound as a ligand, a polythiophene derivative, a polybenzothiadiazole derivative, and a polyfluorene derivative.

Examples of the n-type organic semiconductor include a fullerene and a fullerene derivative ((e.g., fullerenes (higher fullerenes) such as C60, C70, and C74, endohedral fullerene, etc.), or a fullerene derivative (e.g., a fullerene fluoride, a PCBM fullerene compound, a fullerene multimer, etc.)), an organic semiconductor having HOMO and LUMO larger (deeper) than the p-type organic semiconductor, and a transparent inorganic metal oxide.

As the n-type organic semiconductor, there may be specifically used a heterocyclic compound containing a nitrogen atom, an oxygen atom, or a sulfur atoms. Examples of the heterocyclic compound include organic molecules including, as a portion of a molecular skeleton, a pyridine derivative, a pyrazine derivative, a pyrimidine derivative, a triazine derivative, a quinoline derivative, a quinoxaline derivative, an isoquinoline derivative, an acridine derivative, a phenazine derivative, a phenanthroline derivative, a tetrazole derivative, a pyrazole derivative, an imidazole derivative, a thiazole derivative, an oxazole derivative, an imidazole derivative, a benzimidazol derivative, a benzotriazole derivative, a benzoxazole derivative, a benzoxazole derivative, a carbazole derivative, a benzofuran derivative, a dibenzofuran derivative, a subporphyrazine derivative, a polyphenylene vinylene derivative, a polybenzothiadiazole derivative, a polyfluorene derivative, and the like, an organic metal complex, and a subphthalocyanine derivative.

Examples of groups and the like included in the fullerene derivative include: halogen atoms; a straight-chain, branched, or cyclic alkyl group or phenyl group; a group including a straight-chain or condensed aromatic compound; a group including halide; a partial fluoroalkyl group; a perfluoroalkyl group; a silylalkyl group; a silylalkoxy group; an arylsilyl group; an arylsulfanyl group; an alkylsulfanyl group; an arylsulfonyl group; an alkylsulfonyl group; an arylsulfide group; an alkylsulfide group; an amino group; an alkylamino group; an arylamino group; a hydroxy group; an alkoxy group; an acylamino group; an acyloxy group; a carbonyl group; a carboxy group; a carboxamide group; a carboalkoxy group; an acyl group; a sulfonyl group; a cyano group; a nitro group; a group including chalcogenide; a phosphine group; a phosphon group; and derivatives thereof.

A thickness of the photoelectric conversion layer 203 formed from an organic material is, but not limited to, 1 × 10⁻⁸ m or more and 5 × 10⁻⁷ m or less, for example. The thickness of the photoelectric conversion layer 203 is, preferably, 2.5 × 10⁻⁸ m or more and 3 × 10⁻⁷ m or less, more preferably, 2.5 × 10⁻⁸ m or more and 2 × 10⁻⁷ m or less, and still more preferably, 1 × 10⁻⁷ m or more and 1.8 × 10⁻⁷ m or less.

It is to be noted that the organic semiconductors are often classified into p-type and n-type. The p-type means that holes are easily transportable. The n-type means that electrons are easily transportable. Therefore, the organic semiconductor is not limited to the interpretation that it has holes or electrons as majority carriers of thermal excitation, as in inorganic semiconductors.

In addition, examples of a material to form the photoelectric conversion layer 203 that performs photoelectric conversion of light having a wavelength of green include a rhodamine-based dye, a merocyanine-based dye, a quinacridone derivative, a subphthalocyanine-based dye (subphthalocyanine derivative), and the like.

Examples of a material to form the photoelectric conversion layer 203 that performs photoelectric conversion of light having a wavelength of blue include a coumaric acid dye, tris-8-hydroxyquinoline aluminum (Alq3), a merocyanine-based dye, and the like.

Examples of a material to form the photoelectric conversion layer 203 that performs photoelectric conversion of light having a wavelength of red include a phthalocyanine-based dye, a subphthalocyanine-based dye (subphthalocyanine derivative), and the like.

An inorganic material may also be used for the photoelectric conversion layer 203. As the inorganic material, there may be used crystalline silicon, amorphous silicon, microcrystalline silicone, crystalline selenium, amorphous selenium, a chalcopyrite-based compound, or a group III-V compound semiconductor.

Examples of the chalcopyrite-based compound include CIGS (CuInGaSe), CIS (CuInSe₂), CuInS₂, CuAlS₂, CuAlSe₂, CuGaS₂, CuGaSe₂, AgAlS₂, AgAlSe₂, AgInS₂, and AgInSe₂.

Examples of the group III-V compound semiconductor include GaAs, InP, AlGaAs, InGaP, AlGaInP, and InGaAsP. Further examples thereof include CdSe, CdS, In₂Se₃, In₂S₃, Bi₂Se₃, Bi₂S₃, ZnSe, ZnS, PbSe, and PbS.

Additionally, quantum dots including these materials are also usable for the photoelectric conversion layer 203.

In addition, the photoelectric conversion layer 203 may be configured by a stacked structure of a lower semiconductor layer and an upper photoelectric conversion layer, although illustration is omitted. Providing the photoelectric conversion layer 203 with the lower semiconductor layer enables the photoelectric conversion layer 203 to prevent recombination during electric charge accumulation, thus making it possible to improve transfer efficiency of electric charge to the charge transfer layer 202. Further, it is possible to effectively suppress generation of a dark current.

For the upper photoelectric conversion layer, selection may be appropriately made from various materials to form the photoelectric conversion layer 203 described above.

Meanwhile, for the lower semiconductor layer, it is preferable to use a material having a large bandgap value (e.g., a bandgap value of 3.0 eV or more) and having higher mobility than that of a material forming the photoelectric conversion layer 203. Specifically, it may be possible to use an organic semiconductor material such as the above-described oxide semiconductor material such as IGZO, transition metal dichalcogenide, silicon carbide, diamond, graphene, a carbon nano-tube, a condensed polycyclic hydrocarbon compound, and a condensed heterocyclic compound.

In addition, for the lower semiconductor layer, it may be possible to use a material having a larger ionization potential than an ionization potential of the material forming the photoelectric conversion layer 203, in a case where electric charge to be accumulated is an electron.

Meanwhile, for the lower semiconductor layer, it may be possible to use a material having a smaller electron affinity than an electron affinity of the material forming the photoelectric conversion layer 203, in a case where electric charge to be accumulated is a hole.

In addition, it is preferable, for the material forming the lower semiconductor layer, to have an impurity concentration of 1 × 10¹⁸ cm⁻³ or less, for example. The lower semiconductor layer may have a monolayer structure or a multilayer structure. In addition, the material forming the lower semiconductor layer may vary between a region corresponding to the accumulation electrode 201 and a region corresponding to the floating diffusion 13.

### (5-4) Configuration of Electrode 204

The electrode 204 is disposed on the photoelectric conversion layer 203. Here, the electrode 204 is formed across a region corresponding to the plurality of pixels 10. In the same manner as the accumulation electrode 201, for example, IZO or ITO is used as the electrode 204. The electrode 204 is formed to have a film thickness of 20 nm or more and 100 nm or less, for example. In other words, the electrode 204 is an upper electrode of the organic photoelectric conversion section 20.

### (5-5) Configuration of Control Electrode 16

The solid-state imaging device 1 according to the first embodiment includes the two divided accumulation electrodes, i.e., the first accumulation electrode 2011 and the second accumulation electrode 2012, and further includes a control electrode 16. The control electrode 16 is disposed between the first accumulation electrode 2011 and the second accumulation electrode 2012. In the same manner as each of the first accumulation electrode 2011 and the second accumulation electrode 2012, the control electrode 16 is formed in a rectangular shape having a length in the arrow-Y direction being longer than a length in the arrow-X direction in a plan view. Here, the length of the control electrode 16 in the arrow-Y direction is formed to be the same length as the length of each of the first accumulation electrode 2011 and the second accumulation electrode 2012 in the arrow-Y direction.

In the first embodiment, the control electrode 16 is formed to be in the same electrically-conductive layer as each of the first accumulation electrode 2011 and the second accumulation electrode 2012. In addition, the control electrode 16 is formed by the same electrically-conductive material as that of each of the first accumulation electrode 2011 and the second accumulation electrode 2012. The control electrode 16 is supplied with a varying voltage. When the control electrode 16 is supplied with the varying voltage, a height of an energy potential of the charge transfer layer 202 is controlled.

Such a configuration makes it possible to selectively transfer one of electric charge accumulated in the charge transfer layer 202 by the first accumulation electrode 2011 or electric charge accumulated in the charge transfer layer 202 by the second accumulation electrode 2012 to the other thereof. The electric charge is transferred to the floating diffusion 13 disposed in the vicinity of each of the first accumulation electrode 2011 and the second accumulation electrode 2012.

Here, in the pixel (first pixel) 10 disposed on the lower side in FIG. 2, the control electrode 16 corresponds to a "first control electrode" according to the present technology. Meanwhile, in the pixel (second pixel) 10 disposed on the upper side in FIG. 2, the control electrode 16 corresponds to a "second control electrode" according to the present technology.

### (6) Configuration of Optical Lens 22

In the region corresponding to the pixel 10, the optical lens 22 is disposed on the electrode 204 of the organic photoelectric conversion section 20 with a protective film 21 interposed therebetween. The optical lens 22 is formed in a circular shape in a plan view for each of the pixels 10. In addition, the optical lens 22 is formed, for each of the pixels 10, in a curved shape that curves toward the light incident side to condense incident light, as viewed in the arrow-Y direction (hereinafter, referred to as "in a side view").

That is, the optical lens 22 is a so-called on-chip lens, and is integrally formed for each of the pixels 10 or across the plurality of pixels 10. The optical lens 22 is formed by a transparent resin material, for example.

### (7) Configuration of Pixel Region 100

In the solid-state imaging device 1 according to the first embodiment, as described above, the pixel 10 includes the first accumulation electrode 2011, the second accumulation electrode 2012, and the control electrode 16, and is configured as a phase difference detection pixel. Further, the plurality of pixels 10 is arrayed in the arrow-X direction as the first direction and in the arrow-Y direction, which intersects the first direction, as the second direction; the plurality of pixels 10 constructs the pixel region 100. That is, the pixel region 100 is constructed by arranging phase difference detection pixels across the entire surface.

It is to be noted that the pixels 10 as the phase difference detection pixels may be arranged in a portion of the pixel region 100. Specifically, the pixels 10 may be arranged on at least a portion of the left side and the right side in the first direction and on at least a portion of the upper side and the lower side of the second direction of the pixel region 100.

### [Operation of Solid-State Imaging Device 1]

Next, description is given of an electric charge accumulation operation and an electric charge transfer operation of the pixel 10 in the solid-state imaging device 1.

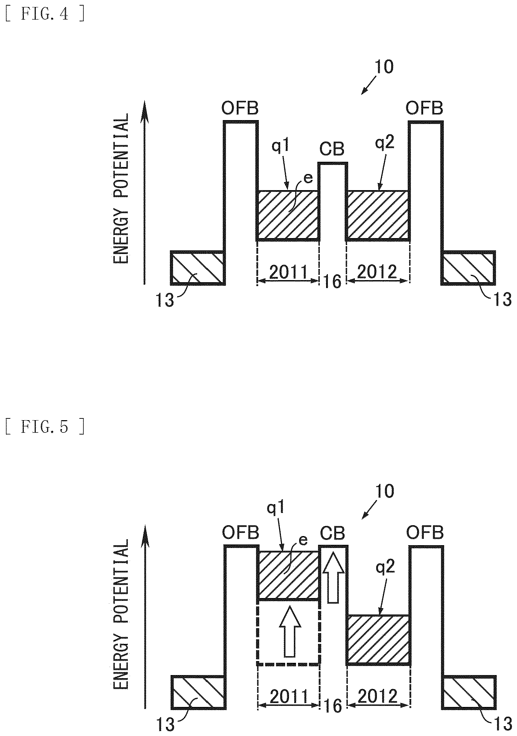

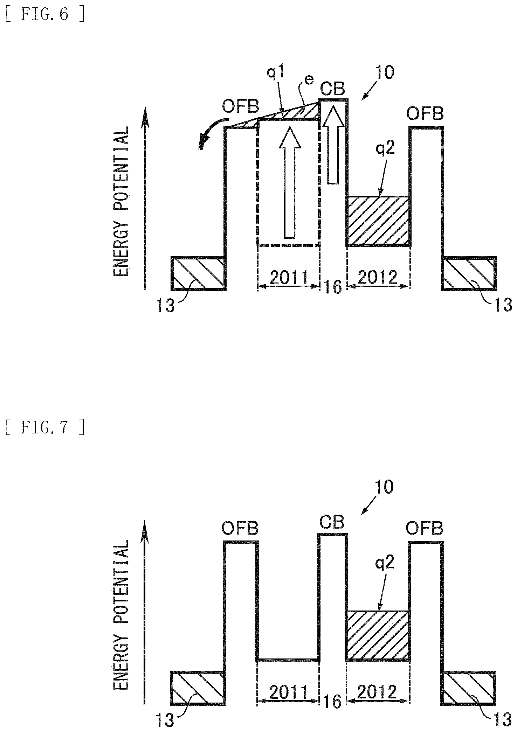

FIG. 4 illustrates an example of an energy potential of the pixel 10 during non-saturated accumulation. FIG. 5 illustrates an example of an energy potential of the pixel 10 at the start of transfer. FIG. 6 illustrates an example of an energy potential of the pixel 10 during the transfer. FIG. 7 illustrates an example of an energy potential of the pixel 10 at the end of the transfer. In each of FIGs. 4 to 7, the horizontal axis indicates respective regions of the floating diffusion 13, the first accumulation electrode 2011, the control electrode 16, the second accumulation electrode 2012, and the floating diffusion 13 of the pixel 10. That is, the horizontal axis indicates the respective regions taken along a cutting line B-B illustrated in FIG. 2 mentioned above. The vertical axis indicates an energy potential of the charge transfer layer 202.

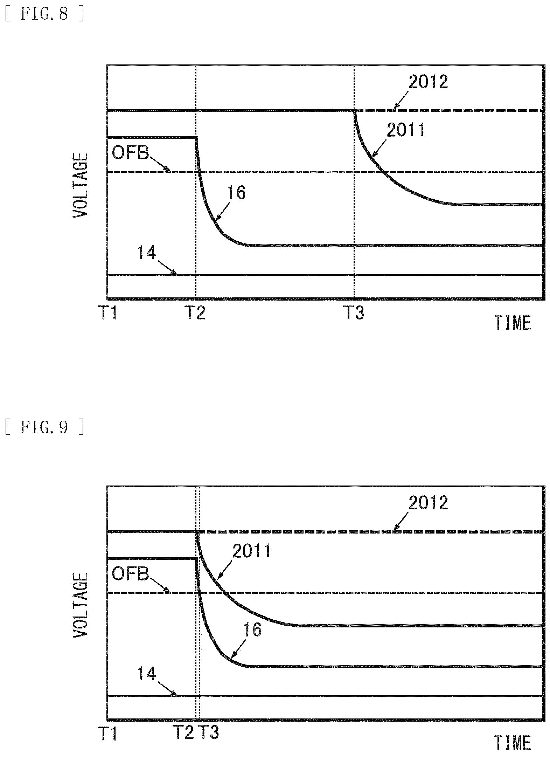

Further, FIG. 8 illustrates an example of an explanatory timing chart of a relationship between time and a voltage supplied to the pixel 10. In FIG. 8, the horizontal axis indicates time. The vertical axis indicates respective voltages supplied to the first electrode 14, the first accumulation electrode 2011, the second accumulation electrode 2012, and the control electrode 16. It is to be noted that a reference symbol OFB denotes an overflow barrier.

### (1) Non-Saturated Accumulation Operation

In a non-saturated accumulation operation, as illustrated in FIG. 8, a voltage higher than a voltage supplied to the first electrode 14 is supplied to each of the first accumulation electrode 2011 and the second accumulation electrode 2012 of the pixel 10 (a timing T1). The first electrode 14 is supplied with a fixed voltage. At this time, the control electrode 16 is supplied with a voltage that is lower than the voltage supplied to each of the first accumulation electrode 2011 and the second accumulation electrode 2012 and that is higher than the voltage supplied to the first electrode 14.

As illustrated in FIG. 4, in the non-saturated accumulation operation, electric charge q1 is accumulated in an energy potential region generated in the charge transfer layer 202 by the first accumulation electrode 2011 and the control electrode 16. The overflow barrier OFB is generated, in the charge transfer layer 202, between the first accumulation electrode 2011 and the floating diffusion 13. The overflow barrier OFB blocks flow of the electric charge q1 to the floating diffusion 13.

Meanwhile, in the non-saturated accumulation operation, electric charge q2 is accumulated in an energy potential region generated in the charge transfer layer 202 by the second accumulation electrode 2012 and the control electrode 16. The overflow barrier OFB is generated, in the charge transfer layer 202, between the second accumulation electrode 2012 and the floating diffusion 13. Likewise, the overflow barrier OFB blocks flow of the electric charge q2 to the floating diffusion 13.

Each of the electric charge q1 and the electric charge q2 is condensed by the optical lens 22, converted from light by the photoelectric conversion layer 203, and accumulated in the charge transfer layer 202.

It is to be noted that, the height of an energy potential becomes smaller in the order of heights of energy potentials generated by the overflow barrier OFB and the control electrode 16, and heights of energy potentials generated by the first accumulation electrode 2011 and the second accumulation electrode 2012.

### (2) Transfer Start Operation

Here, description is given of an operation in which the electric charge q1 accumulated in the charge transfer layer 202 by the first accumulation electrode 2011 is transferred to the floating diffusion 13.

In the transfer start operation, as illustrated in FIG. 8, first, the control electrode 16 starts being supplied with a low voltage (a timing T2). This increases the height of the energy potential generated in the charge transfer layer 202 by the control electrode 16, as illustrated in FIG. 5.

Subsequently, the first accumulation electrode 2011 starts being supplied with a low voltage. This increases the height of the energy potential generated in the charge transfer layer 202 by the first accumulation electrode 2011, thus pushing up the electric charge q1, as illustrated in FIG. 5.

### (3) Transfer Operation

In the transfer operation, as illustrated in FIG. 8, the control electrode 16 and the first accumulation electrode 2011 are supplied with a low voltage (a timing T3). The voltage supplied to the control electrode 16 is lower than the voltage supplied to the first accumulation electrode 2011. This allows a barrier of the energy potential generated in the charge transfer layer 202 by the first accumulation electrode 2011 to be high beyond the overflow barrier OFB, as illustrated in FIG. 6. Additionally, a barrier of the energy potential generated in the charge transfer layer 202 by the control electrode 16 becomes higher than the barrier of the energy potential generated in the charge transfer layer 202 by the first accumulation electrode 2011. This allows the electric charge q1 to flow to the floating diffusion 13 and to be transferred.

### (4) Transfer End Operation

In the transfer end operation, first, the first accumulation electrode 2011 is supplied with a high voltage (see timing T1 in FIG. 8). This allows the barrier of the energy potential generated in the charge transfer layer 202 by the first accumulation electrode 2011 to be lower than the overflow barrier OFB, as illustrated in FIG. 7.

Subsequently, the control electrode 16 is supplied with a high voltage (see timing T1 in FIG. 8). This allows the barrier of the energy potential generated in the charge transfer layer 202 by the first accumulation electrode 2011 to be low, thus returning to a state of the non-saturated accumulation operation, as illustrated in FIG. 4 mentioned above.

It is to be noted that the electric charge q2 accumulated in a region of an energy potential generated in the charge transfer layer 202 by the second accumulation electrode 2012 is similarly transferred to the floating diffusion 13 by sequentially executing the operations of the transfer start operation, the transfer operation, and the transfer end operation described above.

### [Workings and Effects]

As illustrated in FIGs. 2 and 3, the solid-state imaging device 1 according to the first embodiment includes the first electrode 14, the charge transfer layer 202, the photoelectric conversion layer 203, the electrode 204, the first accumulation electrode 2011, the second accumulation electrode 2012, and the control electrode 16.

The first electrode 14 is disposed to surround a portion of a periphery of the pixel (here, the first pixel) 10. The first electrode 14 is supplied with a fixed voltage. The charge transfer layer 202 is disposed at least in a region that is opposed to the first electrode 14 and corresponds to the pixel 10. The charge transfer layer 202 transfers electric charge. The photoelectric conversion layer 203 is disposed on the charge transfer layer 202 on a side opposite to the first electrode 14. The photoelectric conversion layer 203 converts light into electric charge. The electrode 204 is disposed on the photoelectric conversion layer 203 on a side opposite to the charge transfer layer 202. The electrode 204 supplies the photoelectric conversion layer 203 with a voltage.

Here, the first accumulation electrode 2011 and the second accumulation electrode 2012 are disposed to be spaced apart from each other on the charge transfer layer 202 on a side opposite to the photoelectric conversion layer 203 in a region corresponding to the pixel 10. The first accumulation electrode 2011 and the second accumulation electrode 2012 accumulate the electric charge q1 and the electric charge q2, respectively, in the charge transfer layer 202.

Further, a control electrode (here, a first control electrode) 16 is disposed between the first accumulation electrode 2011 and the second accumulation electrode 2012. As illustrated in FIGs. 4 to 8, the control electrode 16 transfers one of the electric charge q1 or the electric charge q2 accumulated by the first accumulation electrode 2011 and the second accumulation electrode 2012.

This allows the pixel 10 to transfer one of the electric charge q1 accumulated in the charge transfer layer 202 by the first accumulation electrode 2011 or the electric charge q2 accumulated in the charge transfer layer 202 by the second accumulation electrode 2012, and to be constructed as a phase difference detection pixel that detects a phase difference. The pixels 10 arrayed across the entire surface of the pixel region 100 enable configuration of phase difference detection pixels across the entire surface of the pixel region 100.

Further, in the solid-state imaging device 1, there is no need to change the shape of the optical lens 22 in order to arrange the phase difference detection pixels. In addition, in the solid-state imaging device 1, there is no need to change the size of the pixel 10 in order to arrange the phase difference detection pixels. Additionally, in the solid-state imaging device 1, there is no need to particularly form a light-blocking region in order to arrange the phase difference detection pixels.

In addition, in the solid-state imaging device 1, as illustrated in FIGs. 2 and 3, the first accumulation electrode 2011 and the second accumulation electrode 2012 are spaced apart from each other in the first direction.

Further, in the solid-state imaging device, the pixel (here, the second pixel) 10 is disposed in the second direction intersecting the first direction, with respect to the pixel (the first pixel) 10. The pixel 10 as the second pixel includes the first electrode 14, the charge transfer layer 202, the electrode 204, the first accumulation electrode 2011, the second accumulation electrode 2012, and the control electrode 16, in the same manner as the pixel 10 as the first pixel.

Here, in the pixel 10 as the second pixel, the first accumulation electrode 2011 corresponds to the "third accumulation electrode" according to the present technology, and the second accumulation electrode 2012 corresponds to the "fourth accumulation electrode" according to the present technology. In addition, the control electrode 16 corresponds to the "second control electrode" according to the present technology.

This enables the pixels 10 as the phase difference detection pixels to be simply arrayed in the second direction, and thus the pixel region 100 to be constructed. It is therefore possible to simply configure the phase difference detection pixels across the entire surface of the pixel region 100.

It is to be noted that, in the present technology, the "arrow-X direction" can be read as the "second direction", and the "arrow-Y direction" can be read as the "first direction", in the solid-state imaging device 1 according to the first embodiment as well as in modification examples and other embodiments described later.

In addition, in the solid-state imaging device 1, as illustrated in FIGs. 4 to 8, the control electrode 16 is supplied with a varying voltage. Additionally, as illustrated in FIGs. 5, 6, and 8, in the transfer start operation to the transfer operation of the pixel 10, the supply of the voltage to the control electrode 16 is started prior to the supply of the voltage to the first accumulation electrode 2011.

When the control electrode 16 is first supplied with a voltage, the height of the energy potential generated in the charge transfer layer 202 becomes higher. It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

In addition, in the solid-state imaging device 1, the control electrode 16 of the pixel 10 is disposed in the same electrically-conductive layer as the first accumulation electrode 2011 and the second accumulation electrode 2012. That is, a distance between the control electrode 16 and the charge transfer layer 202 is close in the same manner as a distance between the charge transfer layer 202 and each of the first accumulation electrode 2011 and the second accumulation electrode 2012.

It is therefore possible to improve controllability of the height of the energy potential generated in the charge transfer layer 202 by an electric field effect from the control electrode 16.

### [First Modification Example]

Description is given, with reference to FIG. 9, of the solid-state imaging device 1 according to a first modification example of the first embodiment.

It is to be noted that, in the first modification example, subsequent modification examples, and embodiments subsequent to the first embodiment, components the same or substantially the same as the components of the solid-state imaging device 1 and the pixel 10 according to the first embodiment are denoted by the same reference numerals, and redundant descriptions are omitted.

### [Operation of Solid-State Imaging Device 1]

FIG. 9 illustrates an example of an explanatory timing chart of a relationship between time and a voltage supplied to the pixel 10. In FIG. 9, the horizontal axis indicates time. The vertical axis indicates respective voltages supplied to the first electrode 14, the first accumulation electrode 2011, the second accumulation electrode 2012, and the control electrode 16.

In contrast to the transfer start operation and the transfer operation of the solid-state imaging device 1 according to the foregoing first embodiment, the transfer start operation and the transfer operation are executed substantially simultaneously in the solid-state imaging device 1 according to the first modification example, as illustrated in FIG. 9.

To describe this in more detail, in the transfer start operation, the control electrode 16 of the pixel 10 starts being supplied with a low voltage (timing T2). Immediately after the transfer start operation and substantially simultaneously, a transfer operation is executed, and the first accumulation electrode 2011 of the pixel 10 starts being supplied with a low voltage (timing T3).

In the first modification example, a supply rate of the voltage to the first accumulation electrode 2011 is set to be slower than a supply rate of the voltage to the control electrode 16.

Components other than the above-described components of the first modification example are the same or substantially the same as the components of the solid-state imaging device 1 and the pixel 10 according to the first embodiment.

### [Workings and Effects]

In the solid-state imaging device 1 according to the first modification example, it is possible to obtain workings and effects similar to the workings and effects obtained by the solid-state imaging device 1 according to the first embodiment.

In addition, in the solid-state imaging device 1, the transfer start operation and the transfer operation are executed substantially simultaneously, as illustrated in FIG. 9. It is therefore possible, in the solid-state imaging device 1, to achieve a higher speed in a transfer speed of the electric charge q1 accumulated in the charge transfer layer 202 by the first accumulation electrode 2011.

Further, in the solid-state imaging device 1, in the transfer operation, the supply rate of the voltage to the first accumulation electrode 2011 is slower than the supply rate of the voltage to the control electrode 16, as illustrated in FIG. 9. That is, in the charge transfer layer 202, the barrier of the energy potential generated by the control electrode 16 first becomes higher than the barrier of the energy potential generated by the first accumulation electrode 2011 (see FIG. 6).

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### [Second Modification Example]

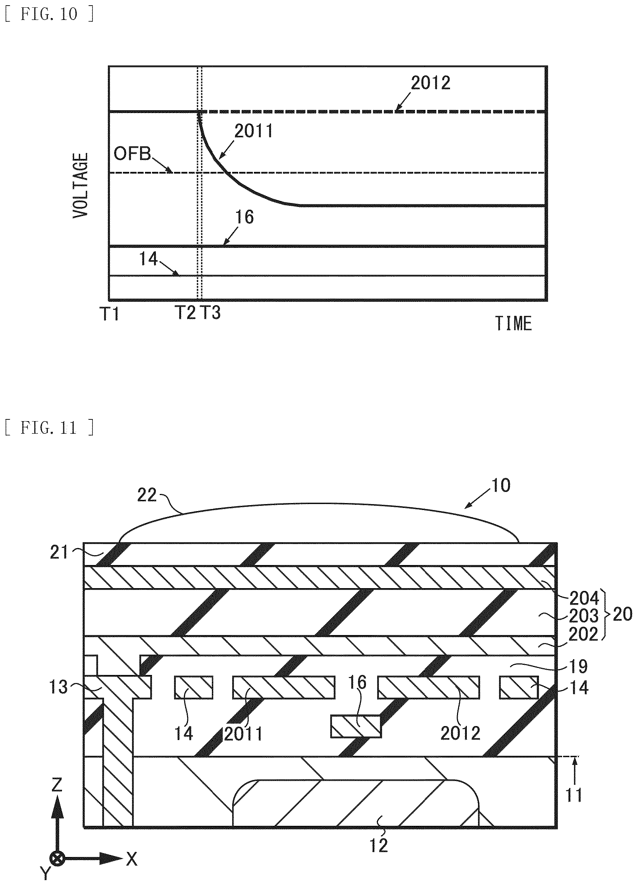

Description is given, with reference to FIG. 10, of the solid-state imaging device 1 according to a second modification example of the first embodiment.

### [Operation of Solid-State Imaging Device 1]

FIG. 10 illustrates an example of an explanatory timing chart of a relationship between time and a voltage supplied to the pixel 10. In FIG. 10, the horizontal axis indicates time. The vertical axis indicates respective voltages supplied to the first electrode 14, the first accumulation electrode 2011, the second accumulation electrode 2012, and the control electrode 16.

In contrast to the transfer start operation and the transfer operation of the solid-state imaging device 1 according to the foregoing first embodiment, the transfer start operation and the transfer operation are changed in the solid-state imaging device 1 according to the second modification example, as illustrated in FIG. 10.

To describe this in more detail, over a period from the non-saturated accumulation operation to the transfer end operation, the control electrode 16 of the pixel 10 is constantly supplied with a fixed low voltage. The voltage supplied to the control electrode 16 is always higher than the voltage supplied to the first electrode 14, and is always lower than the respective voltages supplied to the first accumulation electrode 2011 and the second accumulation electrode 2012.

In the transfer start operation, the first accumulation electrode 2011 of the pixel 10 starts being supplied with a low voltage (timing T2). After the transfer start operation, the transfer operation is started (timing T3). When the barrier of the energy potential generated in the charge transfer layer 202 by the first accumulation electrode 2011 becomes high, the electric charge q1 is transferred to the floating diffusion 13 beyond the overflow barrier OFB.

Components other than the above-described components of the second modification example are the same or substantially the same as the components of the solid-state imaging device 1 and the pixel 10 according to the first embodiment.

### [Workings and Effects]

In the solid-state imaging device 1 according to the second modification example, it is possible to obtain workings and effects similar to the workings and effects obtained by the solid-state imaging device 1 according to the first embodiment.

In addition, in the solid-state imaging device 1, the control electrode 16 of the pixel 10 is constantly supplied with a fixed low voltage over a period from the non-saturated accumulation operation to the transfer end operation, as illustrated in FIG. 10. The transfer start operation is executed, for example, when the first accumulation electrode 2011 is supplied with a low voltage. That is, the transfer start operation and the transfer operation are executed when the first accumulation electrode 2011 is supplied with a voltage, thus making it possible, in the solid-state imaging device 1, to achieve a higher speed in the transfer speed of the electric charge q1 accumulated in the charge transfer layer 202 by the first accumulation electrode 2011.

Further, in the solid-state imaging device 1, the control electrode 16 is constantly supplied with a low voltage over a period from the non-saturated accumulation operation to the transfer end operation, as illustrated in FIG. 10. That is, the control electrode 16 allows the barrier of the energy potential to be always high in the charge transfer layer 202. (see FIG. 6).

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### <2. Second Embodiment>

Description is given, with reference to FIG. 11, of the solid-state imaging device 1 according to the second embodiment of the present disclosure.

FIG. 11 illustrates an example of a longitudinal cross-sectional configuration of the pixel 10 of the solid-state imaging device 1.

As illustrated in FIG. 11, in the solid-state imaging device 1 according to the second embodiment, the control electrode 16 of the pixel 10 is disposed in a different electrically-conductive layer from the first accumulation electrode 2011 and the second accumulation electrode 2012. Here, the control electrode 16 is disposed on a side closer to the semiconductor substrate Sub than the first accumulation electrode 2011 and the second accumulation electrode 2012.

In addition, in the second embodiment, a portion of each of the first accumulation electrode 2011 and the second accumulation electrode 2012 is configured to be extended on the side of the control electrode 16 and to overlap the control electrode 16 in a side view.

Components other than the above-described components of the second embodiment are the same or substantially the same as the components of the solid-state imaging device 1 and the pixel 10 according to the first embodiment.

### [Workings and Effects]

In the solid-state imaging device 1 according to the second embodiment, it is possible to obtain workings and effects similar to the workings and effects obtained by the solid-state imaging device 1 according to the first embodiment.

In addition, in the solid-state imaging device 1 according to the second embodiment, the control electrode 16 of the pixel 10 is configured to be disposed in a different electrically-conductive layer from the first accumulation electrode 2011 and the second accumulation electrode 2012 and to overlap each of the first accumulation electrode 2011 and the second accumulation electrode 2012, as illustrated in FIG. 11. It is therefore possible to increase respective areas of the first accumulation electrode 2011 and the second accumulation electrode 2012, thus making it possible to increase an amount of electric charge accumulated in the charge transfer layer 202.

### <3.Third Embodiment>

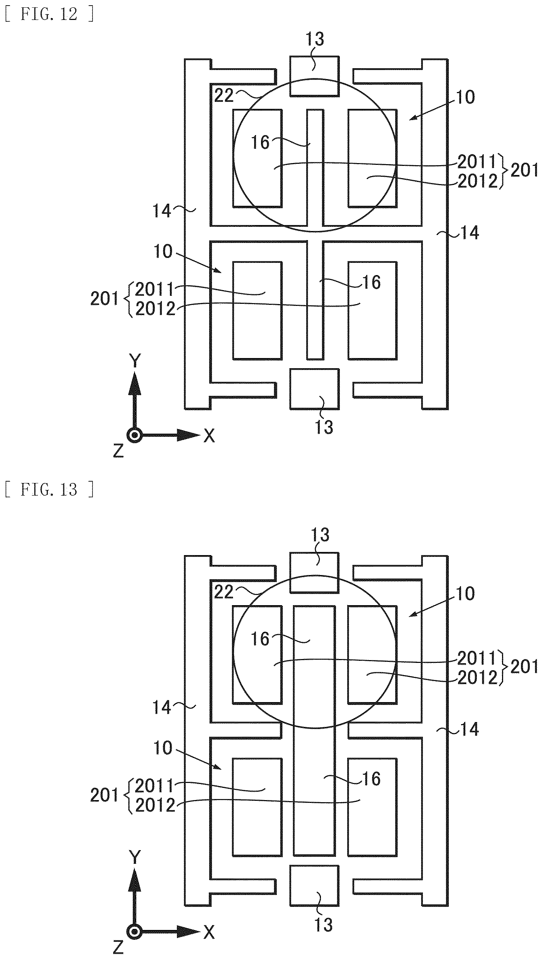

Description is given, with reference to FIG. 12, of the solid-state imaging device 1 according to the third embodiment of the present disclosure.

FIG. 12 illustrates an example of a schematic planar configuration of the pixels 10 of the solid-state imaging device 1.

As illustrated in FIG. 12, in the solid-state imaging device 1 according to the third embodiment, the control electrode 16 of the pixel 10 is disposed in the same electrically-conductive layer as the first electrode 14, the first accumulation electrode 2011, and the second accumulation electrode 2012, and is further electrically coupled to the first electrode 14.

Here, the control-electrode 16 is integrally formed with the first electrode 14, and is supplied with the same fixed potential as the first electrode 14. That is, in the same manner as the solid-state imaging device 1 according to the second modification example of the foregoing first embodiment, the barrier of the energy potential generated in the charge transfer layer 202 by the control electrode 16 is constantly maintained in a high state.

Components other than the above-described components of the third embodiment are the same or substantially the same as the components of the solid-state imaging device 1 and the pixel 10 according to the first embodiment.

### [Workings and Effects]

In the solid-state imaging device 1 according to the third embodiment, it is possible to obtain workings and effects similar to the workings and effects obtained by the solid-state imaging device 1 according to the first embodiment.

In addition, in the solid-state imaging device 1 according to the third embodiment, the control electrode 16 is configured to be electrically coupled to the first electrode 14, as illustrated in FIG. 12, thus making it possible to obtain workings and effects similar to the workings and effects obtained by the solid-state imaging device 1 according to the second modification example of the first embodiment.

In addition, in the solid-state imaging device 1, the control electrode 16 is supplied with a fixed voltage from the first electrode 14, thus making it unnecessary to construct a voltage supply path using another wiring. It is therefore possible to simply achieve a structure of the solid-state imaging device 1.

### <4. Fourth Embodiment>

Description is given, with reference to FIG. 13, of the solid-state imaging device 1 according to the fourth embodiment of the present disclosure.

FIG. 13 illustrates an example of a schematic planar configuration of the pixels 10 of the solid-state imaging device 1.

As illustrated in FIG. 13, the solid-state imaging device 1 according to the fourth embodiment is a modification example of the solid-state imaging device 1 according to the first embodiment or the second embodiment.

To describe this in more detail, in the solid-state imaging device 1, the control electrode (first control electrode) 16 of the pixel (first pixel) 10 is extended in the arrow-Y direction. The extended control electrode (first control electrode) 16 is integrally formed with the control electrode (second control electrode) 16 of another pixel (second pixel) 10 adjacent to the pixel (first pixel) 10 in the arrow-Y direction. The two integrally formed control electrodes 16 are supplied with an equal voltage.

In addition, in the solid-state imaging device 1 according to first embodiment, the control electrode 16 is formed by the same electrically-conductive layer as the first electrode 14. Therefore, a portion (an intermediate part in the arrow-X direction) of the first electrode 14 of the pixel 10 adjacent thereto is removed, and the control electrode 16 is extended to this removed region.

Meanwhile, in the solid-state imaging device 1 according to the second embodiment, the control electrode 16 is formed by a different electrically-conductive layer from the first electrode 14. It is therefore possible to extend the control electrode 16 in the arrow-Y direction in a manner to intersect the first electrode 14 extending in the arrow-X direction.

Components other than the above-described components of the fourth embodiment are the same or substantially the same as the components of the solid-state imaging device 1 and the pixel 10 according to the first embodiment or the second embodiment.

### [Workings and Effects]

In the solid-state imaging device 1 according to the fourth embodiment, it is possible to obtain workings and effects similar to the workings and effects obtained by the solid-state imaging device 1 according to the first embodiment or the second embodiment.

In addition, in the solid-state imaging device 1 according to the third embodiment, the respective control electrodes 16 of the pixels 10 disposed adjacently are integrally coupled together, as illustrated in FIG. 12. In other words, the respective control electrodes 16 are electrically coupled to each other.

It is therefore possible to reduce the number of couplings between the control electrode 16 and unillustrated pieces of wiring that supply voltages thereto, thus making it possible to achieve a simple structure.

### <5. Fifth Embodiment>

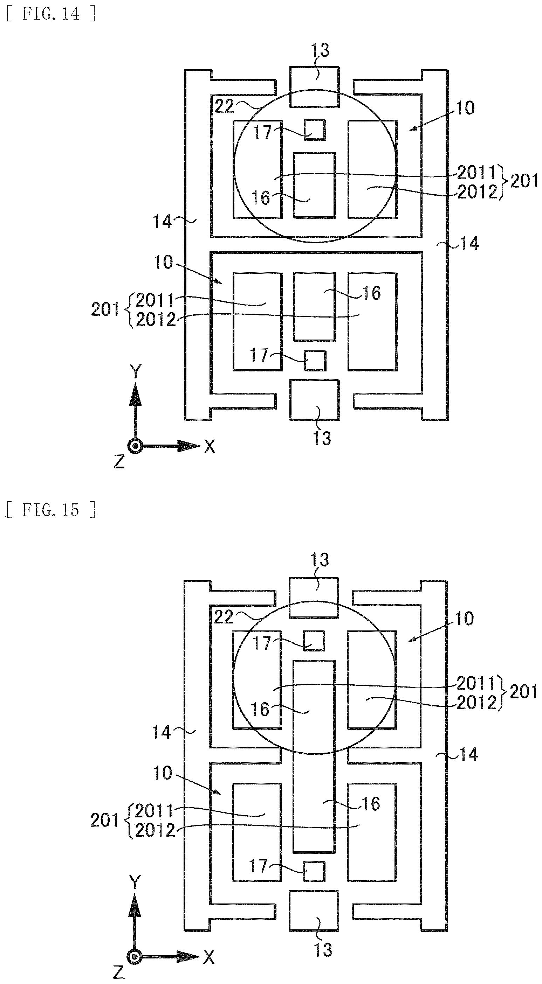

Description is given, with reference to FIG. 14, of the solid-state imaging device 1 according to the fifth embodiment of the present disclosure.

FIG. 14 illustrates an example of a schematic planar configuration of the pixels 10 of the solid-state imaging device 1.

As illustrated in FIG. 14, the solid-state imaging device 1 according to the fifth embodiment is an example in which the solid-state imaging device 1 according to the first embodiment or the second embodiment and the solid-state imaging device 1 according to the third embodiment are combined.

To describe this in more detail, the solid-state imaging device 1 includes a second electrode 17 between the first accumulation electrode 2011 and the second accumulation electrode of the pixel 10 and between the control electrode 16 and the floating diffusion 13. The second electrode 17 is formed in the same electrically-conductive layer as each of the first accumulation electrode 2011 and the second accumulation electrode 2012, and is formed by the same electrically-conductive material as each thereof.

A fixed voltage supplied to the second electrode 17 is, for example, a low voltage equal to or close to the fixed voltage supplied to the first electrode 14.

Components other than the above-described components of the fifth embodiment are the same or substantially the same as the components of the solid-state imaging device 1 and the pixel 10 according to any of the first embodiment to the third embodiment.

### [Workings and Effects]

In the solid-state imaging device 1 according to the fifth embodiment, it is possible to obtain workings and effects similar to the workings and effects obtained by the solid-state imaging device 1 according to the first embodiment or the second embodiment.

In addition, as illustrated in FIG. 14, the solid-state imaging device 1 includes the second electrode 17 between the first accumulation electrode 2011 and the second accumulation electrode 2012 and between the control electrode 16 and the floating diffusion 13. The second electrode 17 is supplied with a fixed voltage, for example, that is equal to the fixed voltage supplied to the first electrode 14, thus allowing the barrier of the energy potential generated in the charge transfer layer 202 to be always high. The barrier of the energy potential is formed as a guide wall that guides the electric charge q1 (see FIG. 6) accumulated in the charge transfer layer 202 by the first accumulation electrode 2011 to the floating diffusion 13. Likewise, the barrier of the energy potential is formed as a guide wall that guides the electric charge q2 (see FIG. 6) accumulated in the charge transfer layer 202 by the second accumulation electrode 2012 to the floating diffusion 13.

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### <6. Sixth Embodiment>

Description is given, with reference to FIG. 15, of the solid-state imaging device 1 according to the sixth embodiment of the present disclosure.

FIG. 15 illustrates an example of a schematic planar configuration of the pixels 10 of the solid-state imaging device 1.

As illustrated in FIG. 15, the solid-state imaging device 1 according to the sixth embodiment is an example in which the solid-state imaging device 1 according to the fourth embodiment and the solid-state imaging device 1 according to the fifth embodiment are combined.

To describe this in more detail, in the solid-state imaging device 1, the respective control electrodes 16 of the pixels 10 adjacent to each other in the arrow-Y direction are integrally formed, and the second electrode 17 is disposed between the control electrode 16 and the floating diffusion 13.

Components other than the above-described components of the sixth embodiment are the same or substantially the same as the components of the solid-state imaging device 1 and the pixel 10 according to the fourth embodiment or the fifth embodiment.

### [Workings and Effects]

In the solid-state imaging device 1 according to the sixth embodiment, it is possible to obtain workings and effects in which the workings and effects obtained by the solid-state imaging device 1 according to the fourth embodiment and the workings and effects obtained by the solid-state imaging device 1 according to the fifth embodiment are combined.

### <7. Seventh Embodiment>

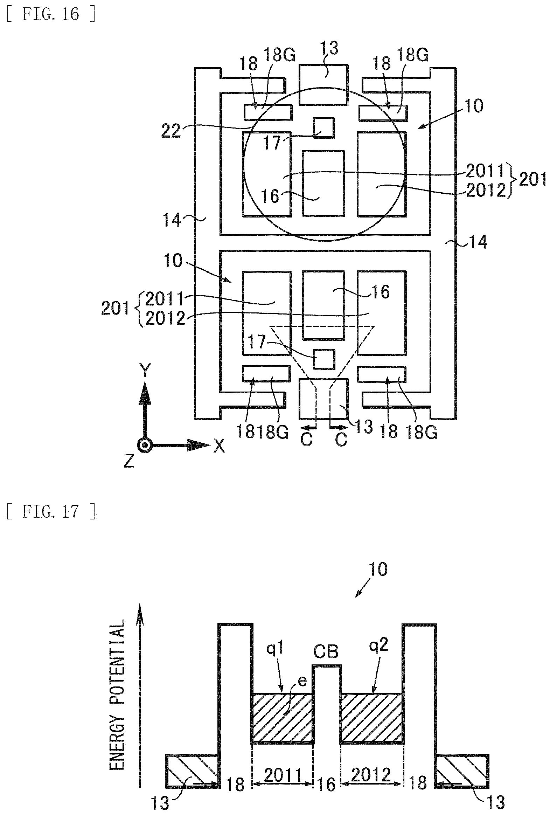

Description is given, with reference to FIG. 16, of the solid-state imaging device 1 according to the seventh embodiment of the present disclosure.

FIG. 16 illustrates an example of a schematic planar configuration of the pixels 10 of the solid-state imaging device 1.

### [Configuration of Solid-State Imaging Device 1]

As illustrated in FIG. 16, the solid-state imaging device 1 according to the seventh embodiment is an example of practical application of the solid-state imaging device 1 according to the fifth embodiment.

To describe this in more detail, in the solid-state imaging device 1, respective switch elements 18 are disposed between the first accumulation electrode 2011 and the floating diffusion 13 of the pixel 10 and between the second accumulation electrode 2012 and the floating diffusion 13. Here, the switch element 18 is configured by the IGFET.

In one of the switch elements 18, the charge transfer layer 202 in a region corresponding to the first accumulation electrode 2011 is configured as one main electrode, whereas the charge transfer layer 202 in a region corresponding to the floating diffusion 13 is configured as another main electrode. In addition, in the switch element 18, a gate electrode 18G is disposed, with a gate insulating film interposed therebetween, in a region corresponding to the charge transfer layer 202 between the main electrodes. The gate insulating film is formed by the insulator 19. The gate electrode 18G is formed, for example, in the same electrically-conductive layer as the first accumulation electrode 2011, and is formed by the same electrically-conductive material.

In another switch element 18, the charge transfer layer 202 in a region corresponding to the second accumulation electrode 2012 is configured as one main electrode, and the charge transfer layer 202 in a region corresponding to the floating diffusion 13 is configured as another main electrode. Likewise, the switch element 18 includes a gate insulating film and the gate electrode 18G.

In the one switch element 18, when the gate electrode 18G is supplied with a voltage, the electric charge q1 accumulated in the charge transfer layer 202 by the first accumulation electrode 2011 is transferred to the floating diffusion 13. Likewise, in the other switch element 18, when the gate electrode 18G is supplied with a voltage, the electric charge q2 accumulated in the charge transfer layer 202 by the second accumulation electrode 2012 is transferred to the floating diffusion 13.

Components other than the above-described components of the seventh embodiment are the same or substantially the same as the components of the solid-state imaging device 1 and the pixel 10 according to the fifth embodiment.

### [Operation of Solid-State Imaging Device 1]

Next, description is given of an electric charge accumulation operation and an electric charge transfer operation of the pixel 10 in the solid-state imaging device 1 described above.

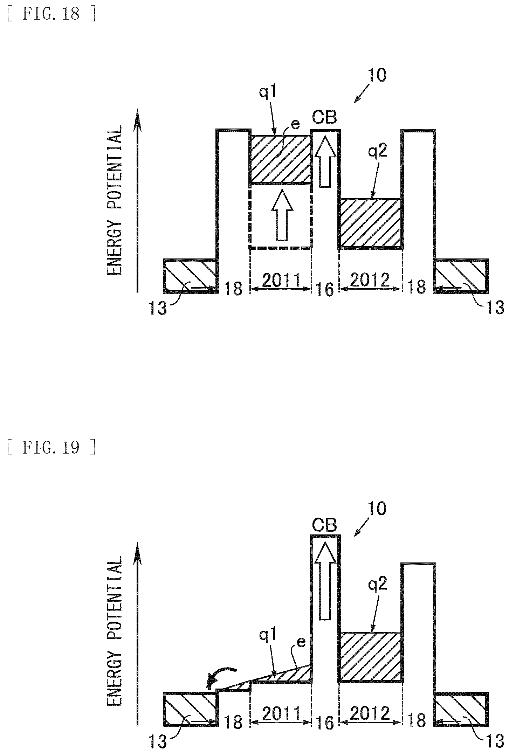

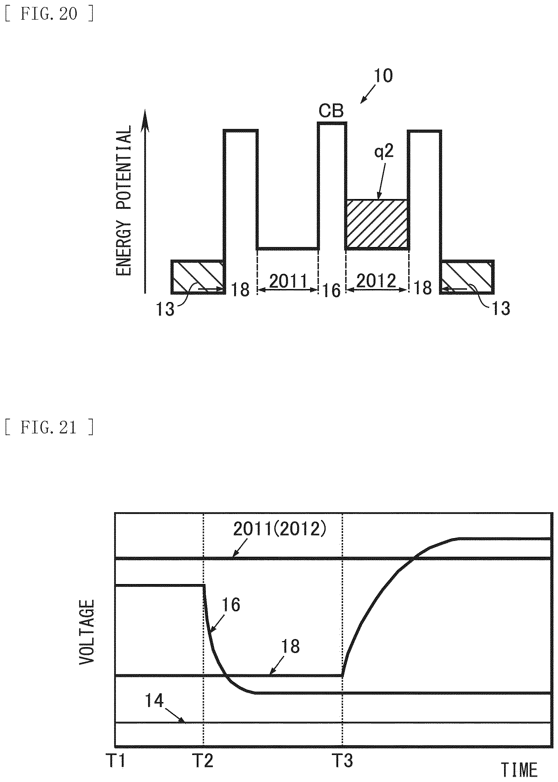

FIG. 17 illustrates an example of an energy potential of the pixel 10 during non-saturated accumulation. FIG. 18 illustrates an example of an energy potential of the pixel 10 during the start of transfer. FIG. 19 illustrates an example of an energy potential of the pixel 10 during the transfer. FIG. 20 illustrates an example of an energy potential of the pixel 10 at the end of the transfer. In FIGs. 17 to 20, the horizontal axis indicates respective regions of the floating diffusion 13, the switch element 18, the first accumulation electrode 2011, the control electrode 16, the second accumulation electrode 2012, the switch element 18, and the floating diffusion 13 of the pixel 10. That is, the horizontal axis corresponds to respective regions taken along a cutting line C-C illustrated in FIG. 16 mentioned above. The vertical axis indicates an energy potential of the charge transfer layer 202.

Further, FIG. 21 illustrates an example of an explanatory timing chart of a relationship between time and a voltage supplied to the pixel 10. In FIG. 21, the horizontal axis indicates time. The vertical axis indicates respective voltages supplied to the first electrode 14, the first accumulation electrode 2011, the second accumulation electrode 2012, the control electrode 16, and the switch element 18.

### (1) Non-Saturated Accumulation Operation

In the non-saturated accumulation operation, as illustrated in FIG. 21, the first accumulation electrode 2011 and the second accumulation electrode 2012 of the pixel 10 are each supplied with a voltage higher than the voltage supplied to the first electrode 14 (timing T1). The first accumulation electrode 2011 and the second accumulation electrode 2012 are each supplied with a fixed voltage over a period from the non-saturated accumulation operation to the transfer end operation. Meanwhile, the first electrode 14 is also supplied with a fixed voltage. At this time, the control electrode 16 is supplied with a voltage that is lower than the voltage supplied to each of the first accumulation electrode 2011 and the second accumulation electrode 2012 and is higher than the voltage supplied to the first electrode 14. Further, the gate electrode 18G of the switch element 18 is supplied with a low voltage that brings it into an OFF state. The gate electrode 18G is supplied with a voltage that is lower than the voltage supplied to the control electrode 16 and is higher than the voltage supplied to the first electrode 14.

As illustrated in FIG. 17, in the non-saturated accumulation operation, the electric charge q1 is accumulated in the energy potential region generated in the charge transfer layer 202 by the first accumulation electrode 2011, the control electrode 16, and the switch element 18. The switch element 18 is brought into an OFF state, and thus the electric charge q1 accumulated in the charge transfer layer 202 by the first accumulation electrode 2011 is not transferred to the floating diffusion 13.

Meanwhile, in the non-saturated accumulation operation, the electric charge q2 is accumulated in the energy potential region generated in the charge transfer layer 202 by the second accumulation electrode 2012, the control electrode 16, and the switch element 18. The switch element 18 is brought into an OFF state, and thus the electric charge q2 accumulated in the charge transfer layer 202 by the second accumulation electrode 2012 is not transferred to the floating diffusion 13.

Each of the electric charge q1 and the electric charge q2 is condensed by the optical lens 22, converted from light by the photoelectric conversion layer 203, and accumulated in the charge transfer layer 202.

It is to be noted that the height of the energy potential becomes smaller in the order of the height of the energy potential generated by the switch element 18, the height of the energy potential generated by the control electrode 16, and the heights of the energy potentials generated by the first accumulation electrode 2011 and the second accumulation electrode 2012.

### (2) Transfer Start Operation

Here, description is given of an operation in which the electric charge q1 accumulated in the charge transfer layer 202 by the first accumulation electrode 2011 is transferred to the floating diffusion 13.

In the transfer start operation, as illustrated in FIG. 21, first, the control electrode 16 starts being supplied with a low voltage (timing T2). This increases the height of the energy potential generated in the charge transfer layer 202 by the control electrode 16, as illustrated in FIG. 18.

### (3) Transfer Operation

In the transfer operation, as illustrated in FIG. 21, a high voltage is supplied to the gate electrode 18G of the switch element 18 disposed between the first accumulation electrode 2011 and the floating diffusion 13, thus bringing the switch element 18 into an ON state (timing T3). This lowers the barrier between the energy potential generated in the charge transfer layer 202 by the first accumulation electrode 2011 and the energy potential generated in the charge transfer layer 202 by the floating diffusion 13, as illustrated in FIG. 19. That is, the electric charge q1 accumulated in the charge transfer layer 202 by the first accumulation electrode 2011 flows to the floating diffusion 13 through the switch element 18 and is transferred.

### (4) Transfer End Operation

In the transfer end operation, a low voltage is supplied to the gate electrode 18G of the switch element 18 to bring the switch element 18 into an OFF state (see timing T1 in FIG. 17). This raises the barrier of the energy potential generated in the charge transfer layer 202 in a region corresponding to the switch element 18, thus returning to a state of the non-saturated accumulation operation.

It is to be noted that sequentially executing the operations of the transfer start operation, the transfer operation, and the transfer end operation described above allows the electric charge q2 accumulated in a region of the energy potential generated in the charge transfer layer 202 by the second accumulation electrode 2012 to be transferred to the floating diffusion 13 in the same manner.

Components other than the above-described components of the seventh embodiment are the same or substantially the same as the components of the solid-state imaging device 1 and the pixel 10 according to the fifth embodiment.

### [Workings and Effects]

In the solid-state imaging device 1 according to the seventh embodiment, it is possible to obtain workings and effects similar to the workings and effects obtained by the solid-state imaging device 1 according to the fifth embodiment.

In addition, as illustrated in FIG. 16, in the solid-state imaging device 1, the respective switch elements 18 are disposed between the first accumulation electrode 2011 and the floating diffusion 13 of the pixel 10 and between the second accumulation electrode 2012 and the floating diffusion 13.

Here, the first accumulation electrode 2011 and the second accumulation electrode 2012 are disposed to be spaced apart from each other on the charge transfer layer 202 on the side opposite to the photoelectric conversion layer 203 in a region corresponding to the pixel 10. The first accumulation electrode 2011 and the second accumulation electrode 2012 accumulate the electric charge q1 and the electric charge q2, respectively, in the charge transfer layer 202.

Further, the control electrode 16 is disposed between the first accumulation electrode 2011 and the second accumulation electrode 2012. As illustrated in FIGs. 17 to 21, the switch element 18 and the control electrode 16 transfer one of the electric charge q1 or the electric charge q2 accumulated by the first accumulation electrode 2011 and the second accumulation electrode 2012.

This allows the pixel 10 to transfer one of the electric charge q1 accumulated in the charge transfer layer 202 by the first accumulation electrode 2011 or the electric charge q2 accumulated in the charge transfer layer 202 by the second accumulation electrode 2012, and to be constructed as a phase difference detection pixel that detects a phase difference. The pixels 10 arrayed across the entire surface of the pixel region 100 enable configuration of phase difference detection pixels across the entire surface of the pixel region 100.

Further, in the solid-state imaging device 1, there is no need to change the shape of the optical lens 22 in order to arrange the phase difference detection pixels. In addition, in the solid-state imaging device 1, there is no need to change the size of the pixel 10 in order to arrange the phase difference detection pixels. Additionally, in the solid-state imaging device 1, there is no need to particularly form a light-blocking region in order to arrange the phase difference detection pixels.

Further, in the solid-state imaging device 1, as illustrated in FIGs. 17, 18, and 21, the control electrode 16 is supplied with a voltage in the transfer start operation to the transfer operation of the pixel 10. Thereafter, in the transfer operation, the switch element 18 is brought into an ON state. When the control electrode 16 is first supplied with a voltage, the height of the energy potential generated in the charge transfer layer 202 becomes higher.

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### [First Modification Example]

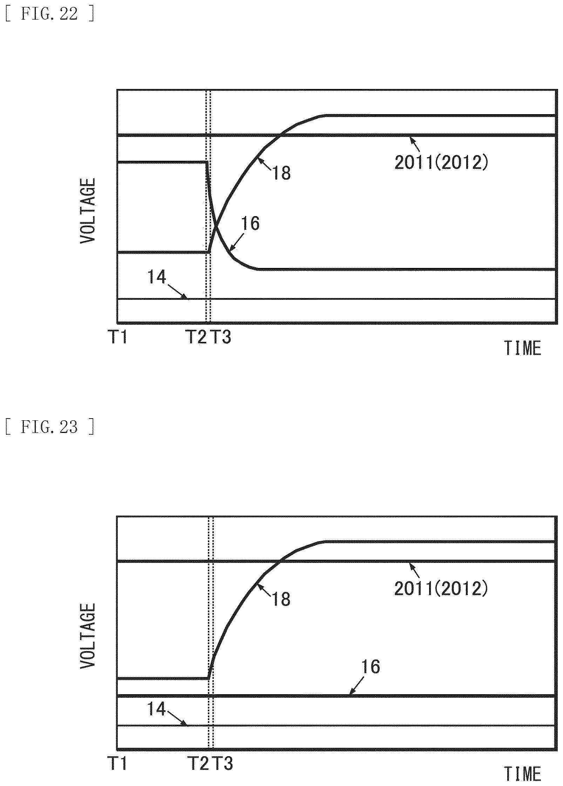

Description is given, with reference to FIG. 22, of the solid-state imaging device 1 according to a first modification example of the seventh embodiment.

### [Operation of Solid-State Imaging Device 1]

FIG. 22 illustrates an example of an explanatory timing chart of a relationship between time and a voltage supplied to the pixel 10. In FIG. 22, the horizontal axis indicates time. The vertical axis indicates respective voltages supplied to the first electrode 14, the first accumulation electrode 2011, the second accumulation electrode 2012, the control electrode 16, and the switch element 18.

In contrast to the transfer start operation and the transfer operation of the solid-state imaging device 1 according to the seventh embodiment, the transfer start operation and the transfer operation are executed substantially simultaneously, in the solid-state imaging device 1 according to the first modification example, as illustrated in FIG. 22.

To describe this in more detail, in the transfer start operation, the control electrode 16 of the pixel 10 starts being supplied with a low voltage (timing T2). Immediately after the transfer start operation and substantially simultaneously, the transfer operation is executed, and the gate electrode 18G of the switch element 18 of the pixel 10 starts being supplied with a high voltage (timing T3). The supply rate of the voltage to the switch element 18 is set to be slower than the supply rate of the voltage to the control electrode 16.

Components other than the above-described components of the first modification example are the same or substantially the same as the components of the solid-state imaging device 1 and the pixel 10 according to the seventh embodiment.

### [Workings and Effects]

In the solid-state imaging device 1 according to the first modification example, it is possible to obtain workings and effects similar to the workings and effects obtained by the solid-state imaging device 1 according to the seventh embodiment.

In addition, in the solid-state imaging device 1, the transfer start operation and the transfer operation are executed substantially simultaneously, as illustrated in FIG. 22. It is therefore possible, in the solid-state imaging device 1, to achieve a higher speed in the transfer speed of the electric charge q1 accumulated in the charge transfer layer 202 by the first accumulation electrode 2011.

Further, in the solid-state imaging device 1, the supply rate of the voltage to the switch element 18 is slower than the supply rate of the voltage to the control electrode 16, in the transfer operation, as illustrated in FIG. 22. That is, in the charge transfer layer 202, the barrier of the energy potential generated by the control electrode 16 first becomes higher, and then the switch element 18 is brought into an ON state to transfer the electric charge q1 (see FIG. 19).

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### [Second Modification Example]

Description is given, with reference to FIG. 23, of the solid-state imaging device 1 according to a second modification example of the seventh embodiment.

### [Operation of Solid-State Imaging Device 1]

FIG. 23 illustrates an example of an explanatory timing chart of a relationship between time and a voltage supplied to the pixel 10. In FIG. 23, the horizontal axis indicates time. The vertical axis indicates respective voltages supplied to the first electrode 14, the first accumulation electrode 2011, the second accumulation electrode 2012, the control electrode 16, and the switch element 18.

In contrast to the transfer start operation and the transfer operation of the solid-state imaging device 1 according to the foregoing seventh embodiment, the transfer start operation and the transfer operation are changed in the solid-state imaging device 1 according to the second modification example, as illustrated in FIG. 23.

To describe this in more detail, over a period from the non-saturated accumulation operation to the transfer end operation, the control electrode 16 of the pixel 10 is constantly supplied with a fixed low voltage. The voltage supplied to the control electrode 16 is always higher than the voltage supplied to the first electrode 14, and is always lower than the respective voltages supplied to the first accumulation electrode 2011 and the second accumulation electrode 2012.

In the transfer start operation, the switch element 18 of the pixel 10 starts being supplied with a high voltage (timing T2). After the transfer start operation, the transfer operation is started (timing T3). The electric charge q1 accumulated in the charge transfer layer 202 by the first accumulation electrode 2011 is transferred to the floating diffusion 13 through the switch element 18.

Components other than the above-described components of the second modification example are the same or substantially the same as the components of the solid-state imaging device 1 and the pixel 10 according to the seventh embodiment.

### [Workings and Effects]

In the solid-state imaging device 1 according to the second modification example, it is possible to obtain workings and effects similar to the workings and effects obtained by the solid-state imaging device 1 according to the seventh embodiment.

In addition, in the solid-state imaging device 1, the control electrode 16 of the pixel 10 is constantly supplied with a fixed low voltage over a period from the non-saturated accumulation operation to the transfer end operation, as illustrated in FIG. 23. The transfer start operation is executed, for example, when the switch element 18 is supplied with a high voltage. That is, the transfer start operation and the transfer operation are executed by bringing the switch element 18 into an ON state, thus making it possible, in the solid-state imaging device 1, to achieve a higher speed in the transfer speed of the electric charge q1 accumulated in the charge transfer layer 202 by the first accumulation electrode 2011.

Further, in the solid-state imaging device 1, the control electrode 16 is constantly supplied with a low voltage over a period from the non-saturated accumulation operation to the transfer end operation, as illustrated in FIG. 23. That is, the control electrode 16 allows the barrier of the energy potential to be always high in the charge transfer layer 202. (see FIG. 19).

It is therefore possible, for example, to effectively suppress or prevent the flow of the electric charge q1 accumulated in the charge transfer layer 202 by the first accumulation electrode 2011 to the electric charge q2 to be accumulated in the charge transfer layer 202 by the second accumulation electrode 2012. That is, it is possible to effectively suppress or prevent blooming.

### <8. Eighth Embodiment>

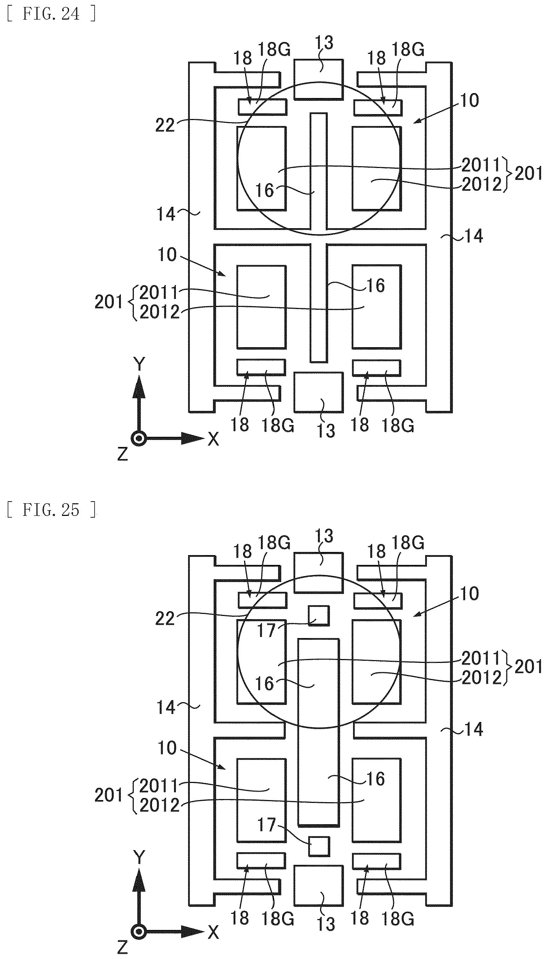

Description is given, with reference to FIG. 24, of the solid-state imaging device 1 according to the eighth embodiment of the present disclosure.

FIG. 24 illustrates an example of a schematic planar configuration of the pixels 10 of the solid-state imaging device 1.

As illustrated in FIG. 24, the solid-state imaging device 1 according to the eighth embodiment is an example in which the solid-state imaging device 1 according to the third embodiment and the solid-state imaging device 1 according to the seventh embodiment are combined.

To describe this in more detail, the solid-state imaging device 1 includes the control electrode 16 between the first accumulation electrode 2011 and the second accumulation electrode of the pixel 10, and includes the switch element 18 between the floating diffusion 13 and each of the first accumulation electrode 2011 and the second accumulation electrode 2012.

The control electrode 16 is supplied with a fixed voltage in the same manner as the control electrode 16 of the solid-state imaging device 1 according to the third embodiment. The fixed voltage is equal to the fixed voltage supplied to the first electrode 14. In addition, the switch element 18 is the same component as the switch element 18 of the solid-state imaging device 1 according to the seventh embodiment.

Components other than the above-described components of the eighth embodiment are the same or substantially the same as the components of the solid-state imaging device 1 and the pixel 10 according to the third embodiment or the seventh embodiment.

### [Workings and Effects]

In the solid-state imaging device 1 according to the eighth embodiment, it is possible to obtain workings and effects in which the workings and effects obtained by the solid-state imaging device according to the third embodiment and the workings and effects obtained by the solid-state imaging device 1 according to the seventh embodiment are combined.

### <9. Ninth Embodiment>

Description is given, with reference to FIG. 25, of the solid-state imaging device 1 according to the ninth embodiment of the present disclosure.

FIG. 25 illustrates an example of a schematic planar configuration of the pixels 10 of the solid-state imaging device 1.

As illustrated in FIG. 25, the solid-state imaging device 1 according to the ninth embodiment is an example in which the solid-state imaging device 1 according to the sixth embodiment and the solid-state imaging device 1 according to the seventh embodiment are combined.

To describe this in more detail, in the solid-state imaging device 1, the respective control electrodes 16 of the pixels 10 adjacent to each other in the arrow-Y direction are integrally formed, and the second electrode 17 is disposed between the control electrode 16 and the floating diffusion 13, in the same manner as the solid-state imaging device 1 according to the sixth embodiment. Further, in the solid-state imaging device 1, the respective switch elements 18 are disposed between the first accumulation electrode 2011 and the floating diffusion 13 of the pixel 10 and between the second accumulation electrode 2012 and the floating diffusion 13.

Components other than the above-described components of the ninth embodiment are the same or substantially the same as the components of the solid-state imaging device 1 and the pixel 10 according to the sixth embodiment or the seventh embodiment.

### [Workings and Effects]

In the solid-state imaging device 1 according to the ninth embodiment, it is possible to obtain workings and effects in which the workings and effects obtained by the solid-state imaging device 1 according to the sixth embodiment and the workings and effects obtained by the solid-state imaging device 1 according to the seventh embodiment are combined.

### <10. Tenth Embodiment>

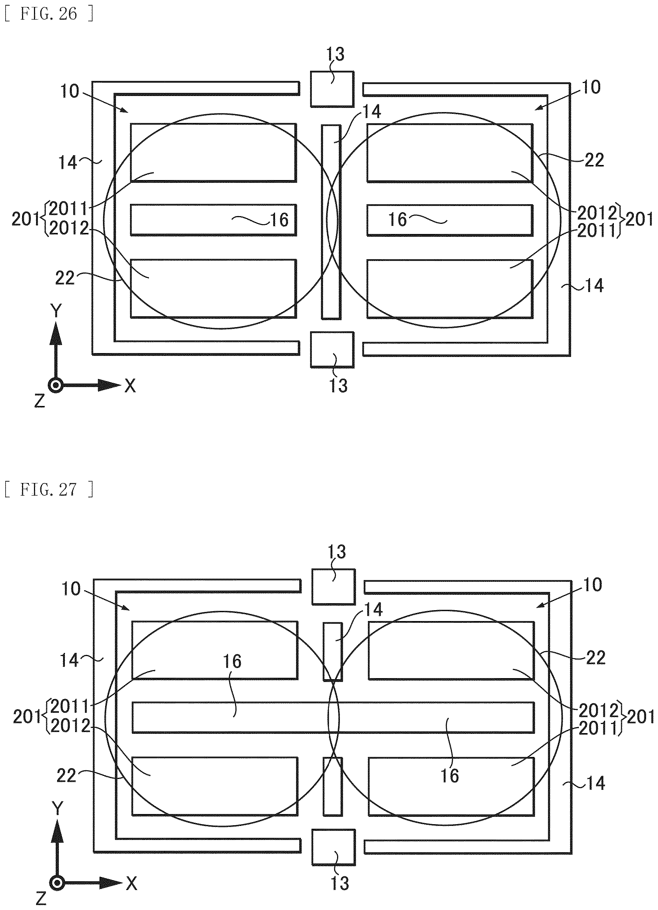

Description is given, with reference to FIG. 26, of the solid-state imaging device 1 according to the tenth embodiment of the present disclosure.

FIG. 26 illustrates an example of a schematic planar configuration of the pixels 10 of the solid-state imaging device 1.

As illustrated in FIG. 26, in the solid-state imaging device 1 according to the tenth embodiment, the configuration of the pixel 10 of the solid-state imaging device 1 according to the first embodiment is changed.

To describe this in more detail, in the pixel 10, the first accumulation electrode 2011 and the second accumulation electrode 2012 are disposed to be spaced apart from each other in the arrow-Y direction as the second direction. The control electrode 16 is disposed between the first accumulation electrode 2011 and the second accumulation electrode 2012.

Meanwhile, in another pixel 10 adjacent to the pixel 10 in the arrow-X direction as the first direction, likewise, the first accumulation electrode 2011 and the second accumulation electrode 2012 are disposed to be spaced apart from each other in the arrow-Y direction, and the control electrode 16 is disposed between the first accumulation electrode 2011 and the second accumulation electrode 2012.

In the vicinity of the respective first accumulation electrodes 2011 of adj acent pixels * between the pixels 10 adjacent to each other in the arrow-X direction, the floating diffusion 13 shared by both of them is disposed. Likewise, in the vicinity of the respective second accumulation electrodes 2012 of the adjacent pixels * between the pixels 10 adjacent to each other in the arrow-X direction, the floating diffusion 13 shared by both of them is disposed.

Components other than the above-described components of the tenth embodiment are the same or substantially the same as the components of the solid-state imaging device 1 and the pixel 10 according to the first embodiment.

### [Workings and Effects]

In the solid-state imaging device 1 according to the tenth embodiment, it is possible to obtain workings and effects similar to the workings and effects obtained by the solid-state imaging device 1 according to the first embodiment.

In particular, the solid-state imaging device 1 is effective in a case where the pixel 10 is driven for phase difference detection in the arrow-Y direction as the second direction.

### <11. Eleventh Embodiment>

Description is given, with reference to FIG. 27, of the solid-state imaging device 1 according to the eleventh embodiment of the present disclosure.

FIG. 27 illustrates an example of a schematic planar configuration of the pixels 10 of the solid-state imaging device 1.

As illustrated in FIG. 27, the solid-state imaging device 1 according to the eleventh embodiment is an example in which the solid-state imaging device 1 according to the fourth embodiment and the solid-state imaging device 1 according to the tenth embodiment are combined.

To describe this in more detail, the respective control electrodes of the pixels 10 adjacent to each other in the arrow-X direction as the first direction are integrally formed.

Components other than the above-described components of the eleventh embodiment are the same or substantially the same as the components of the solid-state imaging device 1 and the pixel 10 according to the fourth embodiment or the tenth embodiment.

### [Workings and Effects]

In the solid-state imaging device 1 according to the eleventh embodiment, it is possible to obtain workings and effects in which the workings and effects obtained by the solid-state imaging device 1 according to the fourth embodiment and the workings and effects obtained by the solid-state imaging device 1 according to the tenth embodiment are combined.

### <12. Twelfth Embodiment>

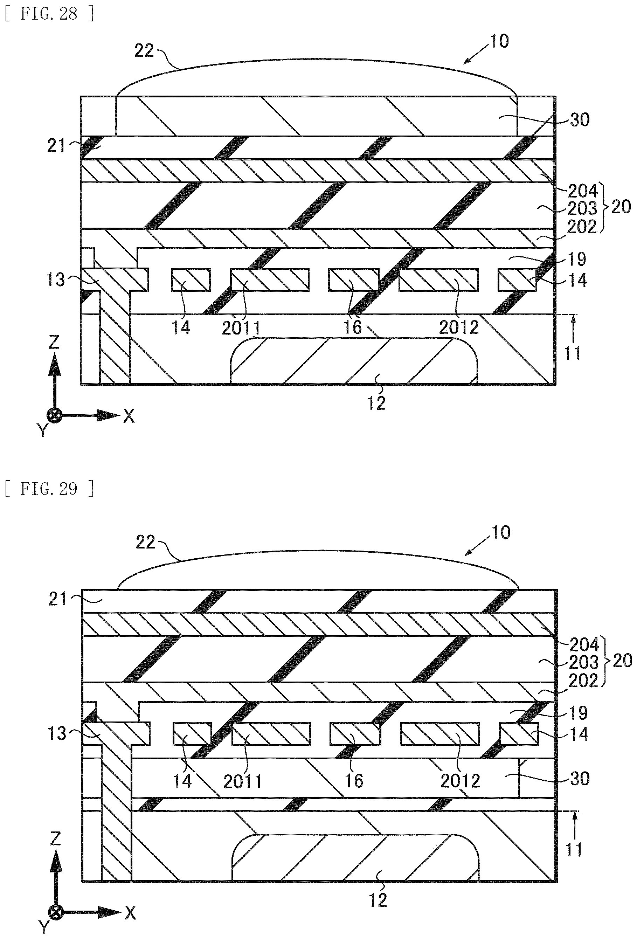

Description is given, with reference to FIG. 28, of the solid-state imaging device 1 according to the twelfth embodiment of the present disclosure.

FIG. 28 illustrates an example of a longitudinal cross-sectional configuration of the pixel 10 of the solid-state imaging device 1.

### [Configuration of Solid-State Imaging Device 1]

As illustrated in FIG. 28, the solid-state imaging device 1 includes a color filter 30 in the pixel 10. Although a planar configuration thereof is omitted, in the solid-state imaging device 1, two pixels 10 arrayed in the arrow-X direction and two pixels 10 arrayed in the arrow-Y direction are configured as a pixel unit, and a plurality of this pixel units is arrayed.

The color filter 30 is disposed between the protective film 21 and the optical lens 22 for each of the pixels 10. The color filter 30 selectively transmits red light (R), green light (G), or blue light (B). For example, the two pixels 10 arranged on one diagonal line of the pixel unit are provided with the color filter 30 that selectively transmits green light. In addition, the two pixels 10 arranged on another diagonal line of the pixel unit are provided with the respective color filters 30 that selectively transmit red light and blue light. That is, the pixel 10 is arrayed in a Bayer shape.

The organic photoelectric conversion section 20 detects light in a visible light region corresponding to each color of the color filter 30. Meanwhile, the inorganic photoelectric conversion section 12 detects light having a wavelength different from the light detected by the organic photoelectric conversion section 20. For example, the light having a different wavelength refers to, for example, infrared light (IR) in an infrared light region having a wavelength of 700 nm or more and 1000 nm or less.

Components other than the above-described components of the twelfth embodiment are the same or substantially the same as the components of the solid-state imaging device 1 and the pixel 10 according to any of the first embodiment to the eleventh embodiment.

### [Workings and Effects]

In the solid-state imaging device 1 according to the twelfth embodiment, it is possible to obtain workings and effects similar to the workings and effects obtained by the solid-state imaging device 1 according to any of the first embodiment to the eleventh embodiment.

In addition, it is possible, in the solid-state imaging device 1, to construct a phase difference detection pixel corresponding to visible light.

### <13. Thirteenth Embodiment>

Description is given, with reference to FIG. 29, of the solid-state imaging device 1 according to the thirteenth embodiment of the present disclosure.

FIG. 29 illustrates an example of a longitudinal cross-sectional configuration of the pixel 10 of the solid-state imaging device 1.

### [Configuration of Solid-State Imaging Device 1]

As illustrated in FIG. 29, the solid-state imaging device 1 is a modification example of the solid-state imaging device 1 according to the twelfth embodiment.

To describe this in more detail, in the solid-state imaging device, the color filter 30 is disposed between the inorganic photoelectric conversion section 12 and the organic photoelectric conversion section 20. Two pixels 10 arranged on one diagonal line of the above-described pixel unit are provided with the color filter 30 that selectively transmits red light. Meanwhile, two pixels 10 arranged on another diagonal line of the pixel unit are provided with the color filter 30 that selectively transmits blue light.

The organic photoelectric conversion section 20 is configured to selectively absorb green light.

The inorganic photoelectric conversion section 12 acquires signals corresponding to red light (R) and blue light (B).

Components other than the above-described components of the thirteenth embodiment are the same or substantially the same as the components of the solid-state imaging device 1 and the pixel 10 according to any of the first embodiment to the eleventh embodiment.

### [Workings and Effects]

In the solid-state imaging device 1 according to the thirteenth embodiment, it is possible to obtain workings and effects similar to the workings and effects obtained by the solid-state imaging device 1 according to any of the first embodiment to the eleventh embodiment.

In addition, it is possible, in the solid-state imaging device 1, to increase areas of the inorganic photoelectric conversion section 12 and the organic photoelectric conversion section 20 that detect red light, blue light, and green light, as compared with the case of having the typical Bayer arrangement. It is therefore possible to construct a phase difference detection pixel that makes it possible to improve an S/N ratio.

### <14. Fourteenth Embodiment>

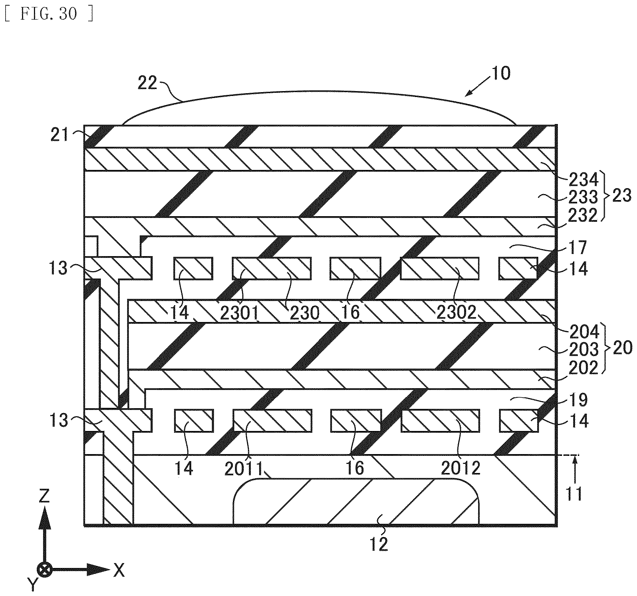

Description is given, with reference to FIG. 30, of the solid-state imaging device 1 according to the fourteenth embodiment of the present disclosure.

FIG. 30 illustrates an example of a longitudinal cross-sectional configuration of the pixel 10 of the solid-state imaging device 1.

### [Configuration of Solid-State Imaging Device 1]

As illustrated in FIG. 30, the solid-state imaging device 1 is modification example of the solid-state imaging device 1 according to any of the first embodiment to the eleventh embodiment.

To describe this in more detail, in the solid-state imaging device 1 according to the first embodiment, the solid-state imaging device further includes, between the organic photoelectric conversion section (a first organic photoelectric conversion section) 20 and the optical lens 22, an organic photoelectric conversion section (a second organic photoelectric conversion section) 23. That is, the solid-state imaging device 1 has a structure in which the inorganic photoelectric conversion section 12, the organic photoelectric conversion section 20, and the organic photoelectric conversion section 23 are sequentially stacked.

The inorganic photoelectric conversion section 12 is, for example, a photoelectric conversion section that absorbs red light having a wavelength of 600 nm or more and 700 nm or less and generates electric charge.

The organic photoelectric conversion section 20 is, for example, a photoelectric conversion section that absorbs green light having a wavelength of 500 nm or more and less than 600 nm and generates electric charge.

Further, the organic photoelectric conversion section 23 is, for example, a photoelectric conversion section that absorbs blue light having a wavelength of 400 nm or more and less than 500 nm and generates electric charge.

It is to be noted that, for example, the organic photoelectric conversion section 20 and the organic photoelectric conversion section 23 may be replaced with each other as appropriate.

In the same manner as the organic photoelectric conversion section 20, the organic photoelectric conversion section 23 includes an accumulation electrode 230, a charge transfer layer 232, a photoelectric conversion layer 233, and an electrode 234. The accumulation electrode 230 includes a first accumulation electrode 2301 and a second accumulation electrode 2302 disposed to be spaced apart from each other. In addition, the control electrode 16 is disposed between the first accumulation electrode 2301 and the second accumulation electrode 2302.

Components other than the above-described components of the fourteenth embodiment are the same or substantially the same as the components of the solid-state imaging device 1 and the pixel 10 according to any of the first embodiment to the eleventh embodiment.

### [Workings and Effects]

In the solid-state imaging device 1 according to the fourteenth embodiment, it is possible to obtain workings and effects similar to the workings and effects obtained by the solid-state imaging device 1 according to any of the first embodiment to the eleventh embodiment.

In addition, the solid-state imaging device 1 has a stacked structure in which the inorganic photoelectric conversion section 12, the organic photoelectric conversion section 20, and the organic photoelectric conversion section 23 are sequentially stacked. It is therefore possible, in the solid-state imaging device 1, to simply construct a phase difference detection pixel that makes it possible to detect red light, blue light, and green light.

### <15. Fifteenth Embodiment>

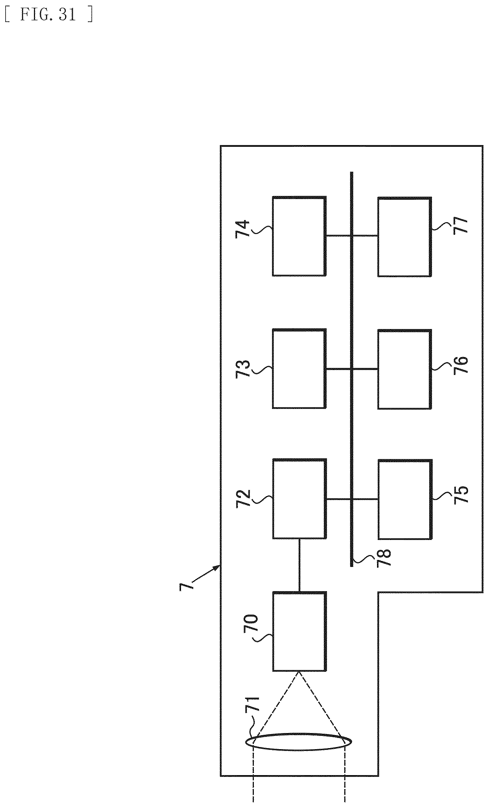

Description is given, with reference to FIG. 31, of the solid-state imaging device 1 according to the fifteenth embodiment of the present disclosure.

FIG. 31 illustrates an example of a block configuration of an electronic apparatus 7.

### [Configuration of Electronic Apparatus 7]

As illustrated in FIG. 31, the electronic apparatus 7 includes, as a photodetector 70, the solid-state imaging device 1 according to any of the first embodiment to the fourteenth embodiment. The photodetector 70 is applied, for example, to various types of electronic apparatuses including an imaging system such as a digital still camera and a video camera, a mobile phone having an imaging function, or another device having an imaging function.

The electronic apparatus 7 includes an optical system 71, the photodetector 70, and a DSP (Digital Signal Processor) 72. In the electronic apparatus 7, the DSP 72, a display device 73, an operation system 74, a memory 75, a recording device 76, and a power supply system 77 are coupled to one another via a bus 78. The electronic apparatus 7 is able to capture a still image and a moving image.

The optical system 71 includes one or a plurality of lenses. The optical system 71 guides image light (incident light) from a subject to the photodetector 70 to form an image on a light-receiving surface (sensor section) of the photodetector 70.

For example, the solid-state imaging device 1 according to any of the first embodiment to the fourteenth embodiment is used as the photodetector 70. In the photodetector 70, electrons are accumulated for a certain period of time in response to an image formed on the light-receiving surface through the optical system 71. Then, the DSP 72 is supplied with a signal corresponding to the electrons accumulated in the photodetector 70.

The DSP 72 performs various types of signal processing on the signal from the photodetector 70 to acquire an image, and causes the memory 75 to temporarily store data on the image. The data on the image stored in the memory 75 are recorded in the recording device 76. In addition, the data on the image stored in the memory 75 are supplied to the display device 73, and the image is displayed in the display device 73. In addition, the operation system 74 accepts various operations by a user, and supplies an operation signal to each of blocks of the electronic apparatus 7. The power supply system 77 supplies power necessary for driving each of the blocks of the electronic apparatus 7.

### [Workings and Effects]

As illustrated in FIG. 31, the electronic apparatus 7 according to the fifteenth embodiment includes the photodetector 70. As described for the solid-state imaging device 1 according to any of the first embodiment to the fourteenth embodiment, the photodetector 70 includes phase difference detection pixels across the entire surface of the pixel region 100, for example. It is therefore possible to improve phase difference detection accuracy of the electronic apparatus 7

### <16. Sixteenth Embodiment>

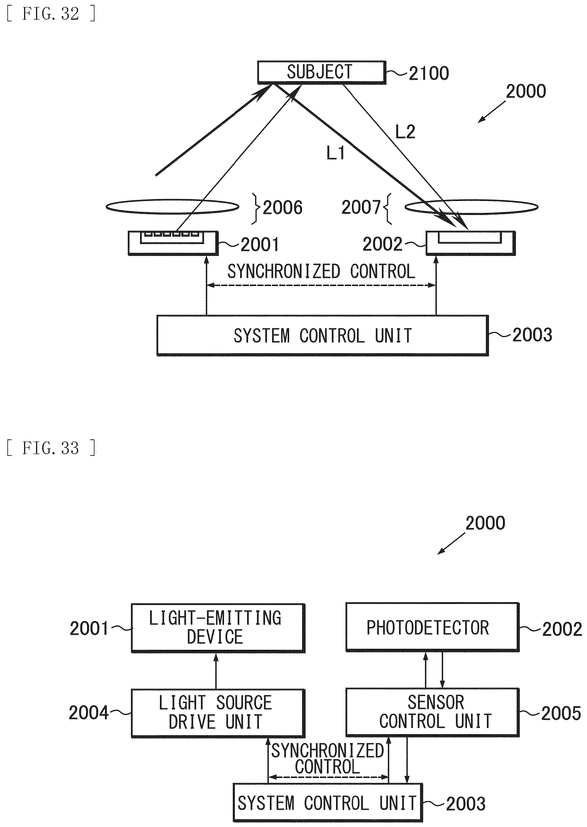

Description is given, with reference to FIGs. 32 and 33, of a photodetection system 2000 according to the sixteenth embodiment of the present disclosure.

FIG. 32 illustrates an example of a system configuration of the photodetection system 2000 including a photodetector 2002. FIG. 33 illustrates an example of a circuit configuration of the photodetection system 2000 illustrated in FIG. 32.

The photodetection system 2000 includes a light-emitting device 2001 as a light source unit that emits infrared light L2 and a photodetector 2002 as a light-receiving unit with a photoelectric conversion element. The above-described solid-state imaging device 1 may be used as the photodetector 2002. The photodetection system 2000 may further include a system control unit 2003, a light source drive unit 2004, a sensor control unit 2005, a light source side optical system 2006, and a camera side optical system 2007.

The photodetector 2002 is able to detect light L1 and light L2. The light L1 is reflected light of ambient light from the outside reflected by a subject (measurement target) 2100. The light L2 is light reflected by the subject 2100 after having been emitted by the light-emitting device 2001. The light L1 is, for example, visible light, and the light L2 is, for example, infrared light. The light L1 is detectable at the photoelectric conversion section in the photodetector 2002. The light L2 is detectable in a photoelectric conversion region in the photodetector 2002. It is possible to acquire image information on the subject 2100 from the light L1 and to acquire information on a distance between the subject 2100 and the photodetection system 2000 from the light L2.

For example, the photodetection system 2000 can be mounted on an electronic apparatus such as a smartphone or on a mobile body such as a car. The light-emitting device 2001 can be configured by, for example, a semiconductor laser, a surface-emitting semiconductor laser, or a vertical resonator surface-emitting laser (VCSEL). For example, an iTOF method can be employed as a method for the photodetector 2002 to detect the light L2 emitted from the light-emitting device 2001. It is to be noted that no limitation is made to this method. In the iTOF method, the photoelectric conversion section measures a distance to the subject 2100 by time of flight of light (TOF: Time-of-Flight), for example. As a method for the photodetector 2002 to detect the light L2 emitted from the light-emitting device 2001, it is possible to adopt, for example, a structured light method or a stereovision method.

For example, in the structured light method, light having a predetermined pattern is projected on the subject 2100, and distortion of the pattern is analyzed, thereby making it possible to measure the distance between the photodetection system 2000 and the subject 2100. In addition, in the stereovision method, for example, two or more cameras are used to acquire two or more images of the subject 2100 viewed from two or more different viewpoints, thereby making it possible to measure the distance between the photodetection system 2000 and the subject. It is to be noted that the system control unit 2003 synchronously controls the light-emitting device 2001 and the photodetector 2002.

### <17. Example of Practical Application to Mobile Body>

The technology according to an embodiment of the present disclosure (present technology) is applicable to various products. For example, the technology according to an embodiment of the present disclosure may be achieved in the form of an apparatus to be mounted to a mobile body of any kind. Non-limiting examples of the mobile body may include an automobile, an electric vehicle, a hybrid electric vehicle, a motorcycle, a bicycle, any personal mobility device, an airplane, an unmanned aerial vehicle (drone), a vessel, and a robot.

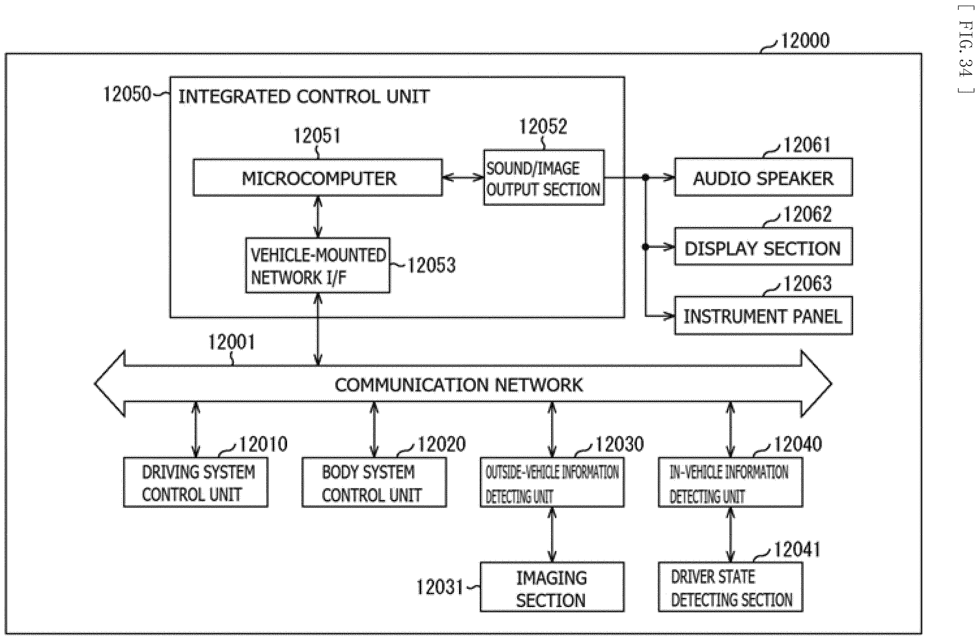

FIG. 34 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 34, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. **In** the example of FIG. 34, an audio speaker 12061, a display section 12062, and an instrument panel 12063 are illustrated as the output device. The display section 12062 may, for example, include at least one of an on-board display and a head-up display.

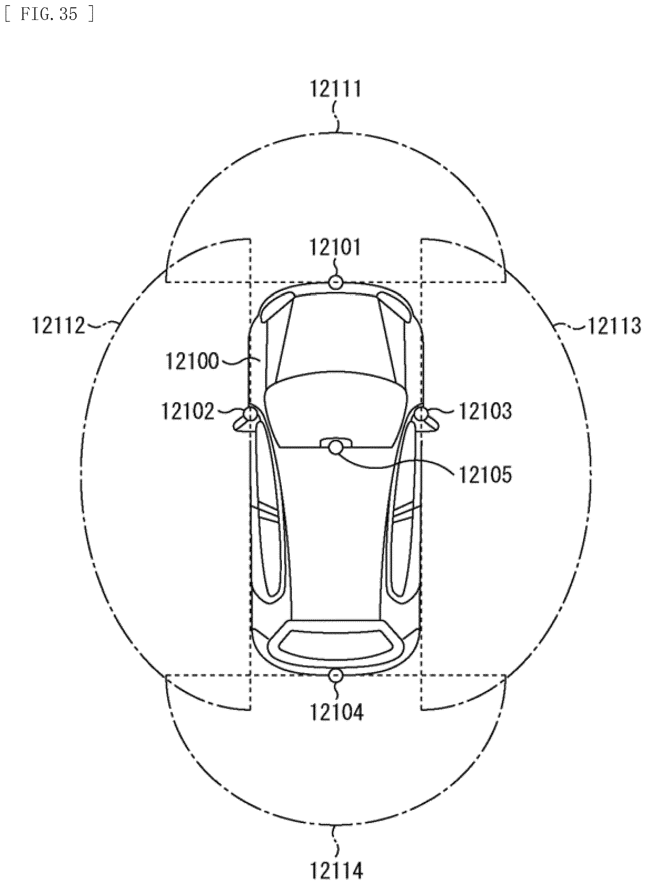

FIG. 35 is a diagram depicting an example of the installation position of the imaging section 12031.

**In** FIG. 35, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 35 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of one example of the vehicle control system, to which the technology according to an embodiment of the present disclosure may be applied. The technology according to an embodiment of the present disclosure may be applied to the imaging section 12031 among components of the configuration described above. The application of the technology according to an embodiment of the present disclosure to the imaging section 12031 enables achievement of the imaging section 12031 of a simpler configuration.

### <18. Example of Practical Application to Endoscopic Surgery System>

The technology according to an embodiment of the present disclosure (present technology) is applicable to various products. For example, the technology according to an embodiment of the present disclosure may be applied to an endoscopic surgery system.

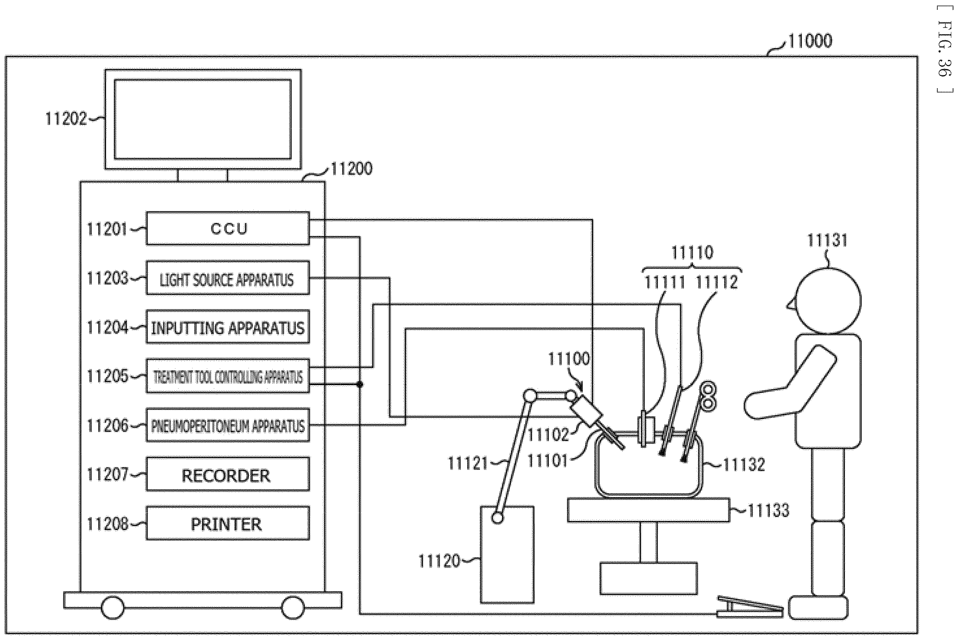

FIG. 36 is a view depicting an example of a schematic configuration of an endoscopic surgery system to which the technology according to an embodiment of the present disclosure (present technology) can be applied.

In FIG. 36, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

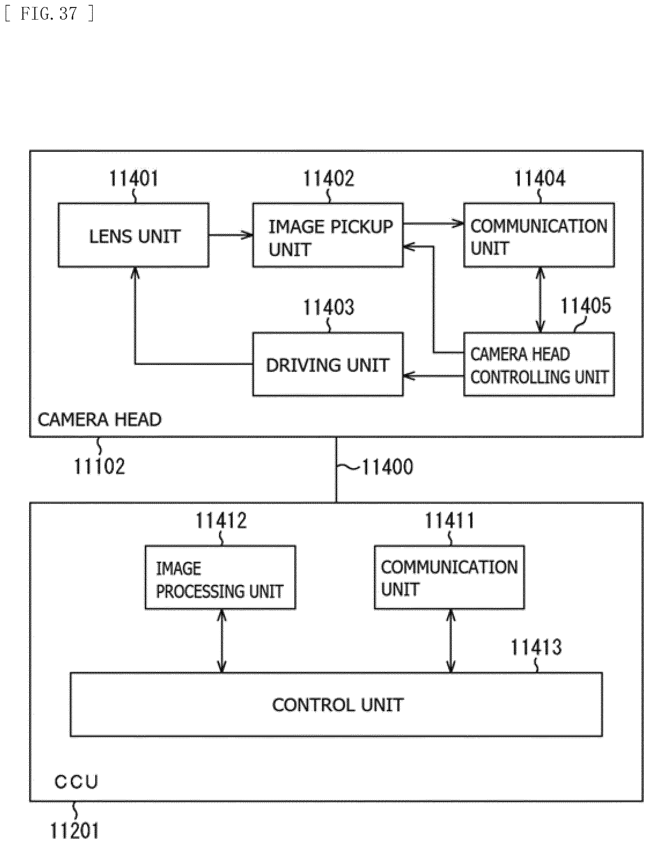

FIG. 37 is a block diagram depicting an example of a functional configuration of the camera head 11102 and the CCU 11201 depicted in FIG. 36.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of one example of the endoscopic surgery system, to which the technology according to an embodiment of the present disclosure is applicable. The technology according to an embodiment of the present disclosure is applicable to, for example, the endoscope 11100, or the image pickup unit 11402 of the camera head 11102. Specifically, the phase difference detection pixel that detects a phase difference is constructed in the image pickup unit 11402. Applying the technology according to an embodiment of the present disclosure enables simple arrangement of the phase difference detection pixels in a predetermined region or across the entire surface of the pixel region in the image pickup unit 11402.

It is to be noted that although the endoscopic surgery system has been described as an example here, the technology according to an embodiment of the present disclosure may also be applied to, for example, a microscopic surgery system, and the like.

### <19. Other Embodiments>

The present technology is not limited to the embodiments described above, and various modifications may be made without departing from the gist of the present technology.

For example, the solid-state imaging devices according to two or more embodiments, among the solid-state imaging devices according to the foregoing first to sixteenth embodiments, may be combined.

A solid-state imaging device according to a first aspect of the present disclosure includes a first electrode, a charge transfer layer, a photoelectric conversion layer, an electrode, a first accumulation electrode and a second accumulation electrode, and a first control electrode.

The first electrode is disposed to surround a portion of a periphery of a first pixel. The first electrode is supplied with a fixed voltage. The charge transfer layer is disposed at least in a region that is opposed to the first electrode and corresponds to the first pixel. The charge transfer layer transfers electric charge. The photoelectric conversion layer is disposed on the charge transfer layer on a side opposite to the first electrode. The photoelectric conversion layer converts light into electric charge. The electrode is disposed on the photoelectric conversion layer on a side opposite to the charge transfer layer. The electrode supplies the photoelectric conversion layer with a voltage.

Here, the first accumulation electrode and the second accumulation electrode are disposed to be spaced apart from each other on the charge transfer layer on a side opposite to the photoelectric conversion layer in a region corresponding to the first pixel. The first accumulation electrode and the second accumulation electrode each accumulate electric charge in the charge transfer layer.

Further, the first control electrode is disposed between the first accumulation electrode and the second accumulation electrode. The first control electrode transfers one of pieces of electric charge accumulated by the first accumulation electrode and the second accumulation electrode.

This allows the first pixel to transfer one of electric charge accumulated in the charge transfer layer by the first accumulation electrode or electric charge accumulated in the charge transfer layer by the second accumulation electrode, and to be constructed as a phase difference detection pixel that detects a phase difference. The first pixels arrayed across the entire surface of a pixel region enable configuration of the phase difference detection pixels across the entire surface of the pixel region.

In a solid-state imaging device according to a second aspect of the present disclosure, the first accumulation electrode and the second accumulation electrode are disposed to be spaced apart from each other in a first direction, in the solid-state imaging device according to the first embodiment. Further, in the solid-state imaging device according to the second embodiment, a second pixel is disposed in a second direction intersecting the first direction, with respect to the first pixel.

The second pixel includes the first electrode, the charge transfer layer, the photoelectric conversion layer, the electrode, a third accumulation electrode and a fourth accumulation electrode, and a second control electrode.

The first electrode is disposed to surround a portion of a periphery of the second pixel. The first electrode is supplied with a fixed voltage. The charge transfer layer is disposed at least in a region that is opposed to the first electrode and corresponds to the second pixel. The charge transfer layer transfers electric charge. The photoelectric conversion layer is disposed on the charge transfer layer on a side opposite to the first electrode. The photoelectric conversion layer converts light into electric charge. The electrode is disposed on the photoelectric conversion layer on a side opposite to the charge transfer layer. The electrode supplies the photoelectric conversion layer with a voltage.

Here, the third accumulation electrode and the fourth accumulation electrode are disposed to be spaced apart from each other on the charge transfer layer on a side opposite to the photoelectric conversion layer in a region corresponding to the second pixel. The third accumulation electrode and the fourth accumulation electrode each accumulate electric charge in the charge transfer layer.

Further, the second control electrode is disposed between the third accumulation electrode and the fourth accumulation electrode. The second control electrode transfers one of pieces of electric charge accumulated by the third accumulation electrode and the fourth accumulation electrode.

This allows the second pixel to transfer one of electric charge accumulated in the charge transfer layer by the third accumulation electrode or electric charge accumulated in the charge transfer layer by the fourth accumulation electrode, and to be constructed as a phase difference detection pixel that detects a phase difference. The first pixels and the second pixels arrayed across the entire surface of a pixel region enable configuration of the phase difference detection pixels across the entire surface of the pixel region.

### <Configuration of Present Technology>

The present technology has the following configurations. According to the present technology of the following configurations, it is possible, in the solid-state imaging device, to simply arrange phase difference detection pixels in a predetermined region or across the entire surface of the pixel region.
(1) A solid-state imaging device including:
   a first electrode disposed to surround a portion of a periphery of a first pixel and being supplied with a fixed voltage;
   a charge transfer layer disposed at least in a region that is opposed to the first electrode and corresponds to the first pixel, the charge transfer layer transferring electric charge;
   a photoelectric conversion layer disposed on the charge transfer layer on a side opposite to the first electrode, the photoelectric conversion layer converting light into electric charge;
   an electrode disposed on the photoelectric conversion layer on a side opposite to the charge transfer layer, the electrode supplying the photoelectric conversion layer with a voltage;
   a first accumulation electrode and a second accumulation electrode disposed to be spaced apart from each other on the charge transfer layer on a side opposite to the photoelectric conversion layer in a region corresponding to the first pixel, the first accumulation electrode and the second accumulation electrode each accumulating electric charge in the charge transfer layer; and
   a first control electrode disposed between the first accumulation electrode and the second accumulation electrode, the first control electrode transferring one of pieces of electric charge accumulated by the first accumulation electrode and the second accumulation electrode.
(2) The solid-state imaging device according to (1), in which the first pixel includes a phase difference detection pixel that detects a phase difference.
(3) The solid-state imaging device according to (1) or (2), in which the first control electrode is supplied with a varying voltage.
(4) The solid-state imaging device according to (1) or (2), in which the first control electrode is supplied with a fixed voltage.
(5) The solid-state imaging device according to any one of (1) to (4), in which a floating diffusion that transfers accumulated electric charge is disposed in a vicinity of each of the first accumulation electrode and the second accumulation electrode.
(6) The solid-state imaging device according to any one of (1) to (5), in which the first accumulation electrode and the second accumulation electrode are disposed to be spaced apart from each other in a first direction.
(7) The solid-state imaging device according to (6), in which
   a second pixel is disposed in a second direction with respect to the first pixel, the second direction intersecting the first direction, and
   the second pixel includes
      the first electrode disposed to surround a portion of a periphery of the second pixel and being supplied with a fixed voltage,
      the charge transfer layer disposed at least in a region that is opposed to the first electrode and corresponds to the second pixel, the charge transfer layer transferring electric charge,
      the photoelectric conversion layer disposed on the charge transfer layer on the side opposite to the first electrode, the photoelectric conversion layer converting light into electric charge,
      the electrode disposed on the photoelectric conversion layer on the side opposite to the charge transfer layer, the electrode applying a voltage to the photoelectric conversion layer,
      a third accumulation electrode and a fourth accumulation electrode disposed to be spaced apart from each other in the first direction on the charge transfer layer on the side opposite to the photoelectric conversion layer in a region corresponding to the second pixel, the third accumulation electrode and the fourth accumulation electrode each accumulating electric charge in the charge transfer layer, and
      a second control electrode disposed between the third accumulation electrode and the fourth accumulation electrode, the second control electrode transferring one of pieces of electric charge accumulated by the third accumulation electrode and the fourth accumulation electrode.
(8) The solid-state imaging device according to (7), in which the second control electrode is integrally formed with the first control electrode.
(9) The solid-state imaging device according to (7) or (8), in which a second electrode is disposed between the floating diffusion and each of the first control electrode and the second control electrode, the second electrode being supplied with a fixed voltage.
(10) The solid-state imaging device according to (9), in which the fixed voltage supplied to the second electrode is equal to the fixed voltage supplied to the first electrode.
(11) The solid-state imaging device according to any one of (1) to (10), in which respective switch elements are disposed between the first accumulation electrode and the floating diffusion and between the second accumulation electrode and the floating diffusion.
(12) The solid-state imaging device according to any one of (1) to (5), in which
   the first accumulation electrode and the second accumulation electrode are disposed to be spaced apart from each other in a second direction,
   a second pixel is disposed in a first direction with respect to the first pixel, the first direction intersecting the second direction, and
   the second pixel includes
      the first electrode disposed to surround a portion of a periphery of the second pixel and being supplied with a fixed voltage,
      the charge transfer layer disposed at least in a region that is opposed to the first electrode and corresponds to the second pixel, the charge transfer layer transferring electric charge,
      the photoelectric conversion layer disposed on the charge transfer layer on the side opposite to the first electrode, the photoelectric conversion layer converting light into electric charge,
      the electrode disposed on the photoelectric conversion layer on the side opposite to the charge transfer layer, the electrode supplying the photoelectric conversion layer with a voltage,
      a third accumulation electrode and a fourth accumulation electrode disposed to be spaced apart from each other in the second direction on the charge transfer layer on the side opposite to the photoelectric conversion layer in a region corresponding to the second pixel, the third accumulation electrode and the fourth accumulation electrode each accumulating electric charge in the charge transfer layer, and
      a second control electrode disposed between the third accumulation electrode and the fourth accumulation electrode, the second control electrode transferring one of pieces of electric charge accumulated by the third accumulation electrode and the fourth accumulation electrode.
(13) The solid-state imaging device according to (12), in which a floating diffusion that transfers accumulated electric charge is disposed in a vicinity of each of the first accumulation electrode and the third accumulation electrode and in a vicinity of each of the second accumulation electrode and the fourth accumulation electrode.
(14) The solid-state imaging device according to (9), in which the first control electrode and the second control electrode are formed in a same electrically-conductive layer as each of the first accumulation electrode, the second accumulation electrode, the third accumulation electrode, and the fourth accumulation electrode.
(15) The solid-state imaging device according to (9), in which the first control electrode and the second control electrode are formed in a different electrically-conductive layer from each of the first accumulation electrode, the second accumulation electrode, the third accumulation electrode, and the fourth accumulation electrode.
(16) The solid-state imaging device according to (7) or (12), in which a plurality of the first pixels and a plurality of the second pixels are each arrayed in the first direction and the second direction and construct a pixel region.
(17) The solid-state imaging device according to (7) or (12), in which an optical lens having a circular shape in a plan view is disposed on the electrode on a side opposite to the photoelectric conversion layer in each of regions corresponding to the first pixel and the second pixel.

The present application claims the benefit of Japanese Priority Patent Application JP2022-099008 filed with the Japan Patent Office on June 20, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A solid-state imaging device comprising:
a first electrode disposed to surround a portion of a periphery of a first pixel and being supplied with a fixed voltage;
a charge transfer layer disposed at least in a region that is opposed to the first electrode and corresponds to the first pixel, the charge transfer layer transferring electric charge;
a photoelectric conversion layer disposed on the charge transfer layer on a side opposite to the first electrode, the photoelectric conversion layer converting light into electric charge;
an electrode disposed on the photoelectric conversion layer on a side opposite to the charge transfer layer, the electrode supplying the photoelectric conversion layer with a voltage;
a first accumulation electrode and a second accumulation electrode disposed to be spaced apart from each other on the charge transfer layer on a side opposite to the photoelectric conversion layer in a region corresponding to the first pixel, the first accumulation electrode and the second accumulation electrode each accumulating electric charge in the charge transfer layer; and
a first control electrode disposed between the first accumulation electrode and the second accumulation electrode, the first control electrode transferring one of pieces of electric charge accumulated by the first accumulation electrode and the second accumulation electrode.

2. The solid-state imaging device according to claim 1, wherein the first pixel comprises a phase difference detection pixel that detects a phase difference.

3. The solid-state imaging device according to claim 2, wherein the first control electrode is supplied with a varying voltage .

4. The solid-state imaging device according to claim 2, wherein the first control electrode is supplied with a fixed voltage.

5. The solid-state imaging device according to claim 1, wherein a floating diffusion that transfers accumulated electric charge is disposed in a vicinity of each of the first accumulation electrode and the second accumulation electrode.

6. The solid-state imaging device according to claim 1, wherein the first accumulation electrode and the second accumulation electrode are disposed to be spaced apart from each other in a first direction.

7. The solid-state imaging device according to claim 6, wherein
a second pixel is disposed in a second direction with respect to the first pixel, the second direction intersecting the first direction, and
the second pixel includes
the first electrode disposed to surround a portion of a periphery of the second pixel and being supplied with a fixed voltage,
the charge transfer layer disposed at least in a region that is opposed to the first electrode and corresponds to the second pixel, the charge transfer layer transferring electric charge,
the photoelectric conversion layer disposed on the charge transfer layer on the side opposite to the first electrode, the photoelectric conversion layer converting light into electric charge,
the electrode disposed on the photoelectric conversion layer on the side opposite to the charge transfer layer, the electrode applying a voltage to the photoelectric conversion layer,
a third accumulation electrode and a fourth accumulation electrode disposed to be spaced apart from each other in the first direction on the charge transfer layer on the side opposite to the photoelectric conversion layer in a region corresponding to the second pixel, the third accumulation electrode and the fourth accumulation electrode each accumulating electric charge in the charge transfer layer, and
a second control electrode disposed between the third accumulation electrode and the fourth accumulation electrode, the second control electrode transferring one of pieces of electric charge accumulated by the third accumulation electrode and the fourth accumulation electrode.

8. The solid-state imaging device according to claim 7, wherein the second control electrode is integrally formed with the first control electrode.

9. The solid-state imaging device according to claim 7, wherein a second electrode is disposed between a floating diffusion and each of the first control electrode and the second control electrode, the second electrode being supplied with a fixed voltage.

10. The solid-state imaging device according to claim 9, wherein the fixed voltage supplied to the second electrode is equal to the fixed voltage supplied to the first electrode.

11. The solid-state imaging device according to claim 5, wherein respective switch elements are disposed between the first accumulation electrode and the floating diffusion and between the second accumulation electrode and the floating diffusion.

12. The solid-state imaging device according to claim 1, wherein
the first accumulation electrode and the second accumulation electrode are disposed to be spaced apart from each other in a second direction,
a second pixel is disposed in a first direction with respect to the first pixel, the first direction intersecting the second direction, and
the second pixel includes
the first electrode disposed to surround a portion of a periphery of the second pixel and being supplied with a fixed voltage,
the charge transfer layer disposed at least in a region that is opposed to the first electrode and corresponds to the second pixel, the charge transfer layer transferring electric charge,
the photoelectric conversion layer disposed on the charge transfer layer on the side opposite to the first electrode, the photoelectric conversion layer converting light into electric charge,
the electrode disposed on the photoelectric conversion layer on the side opposite to the charge transfer layer, the electrode supplying the photoelectric conversion layer with a voltage,
a third accumulation electrode and a fourth accumulation electrode disposed to be spaced apart from each other in the second direction on the charge transfer layer on the side opposite to the photoelectric conversion layer in a region corresponding to the second pixel, the third accumulation electrode and the fourth accumulation electrode each accumulating electric charge in the charge transfer layer, and
a second control electrode disposed between the third accumulation electrode and the fourth accumulation electrode, the second control electrode transferring one of pieces of electric charge accumulated by the third accumulation electrode and the fourth accumulation electrode.

13. The solid-state imaging device according to claim 12, wherein a floating diffusion that transfers accumulated electric charge is disposed in a vicinity of each of the first accumulation electrode and the third accumulation electrode and in a vicinity of each of the second accumulation electrode and the fourth accumulation electrode.

14. The solid-state imaging device according to claim 9, wherein the first control electrode and the second control electrode are formed in a same electrically-conductive layer as each of the first accumulation electrode, the second accumulation electrode, the third accumulation electrode, and the fourth accumulation electrode.

15. The solid-state imaging device according to claim 9, wherein the first control electrode and the second control electrode are formed in a different electrically-conductive layer from each of the first accumulation electrode, the second accumulation electrode, the third accumulation electrode, and the fourth accumulation electrode.

16. The solid-state imaging device according to claim 7, wherein a plurality of the first pixels and a plurality of the second pixels are each arrayed in the first direction and the second direction and construct a pixel region.

17. The solid-state imaging device according to claim 7, wherein an optical lens having a circular shape in a plan view is disposed on the electrode on a side opposite to the photoelectric conversion layer in each of regions corresponding to the first pixel and the second pixel.
